# EUROPÄISCHE PATENTSCHRIFT

(11) **EP 2 893 556 B1**
(45) Veröffentlichungstag und Bekanntmachung des Hinweises auf die Patenterteilung: **10.01.2018**
(21) Anmeldenummer: 13802610.9
(22) Anmeldetag: 06.12.2013
(51) Int. Cl.: H01L 21/66, H01L 21/67, H01L 21/68, H01L 21/683

(54) **VORRICHTUNG UND VERFAHREN ZUM AUSRICHTEN VON SUBSTRATEN**
DEVICE AND METHOD FOR ALIGNING SUBSTRATES
DISPOSITIF ET PROCÉDÉ D'ALIGNEMENT DE SUBSTRATS

(43) Veröffentlichungstag der Anmeldung: 15.07.2015
(73) Patentinhaber: Ev Group E. Thallner GmbH, 4782 St. Florian am Inn (AT)
(72) Erfinder: WAGENLEITNER, Thomas, 4971 Aurolzmünster (AT)
(74) Vertreter: Schweiger, Johannes
(86) Internationale Anmeldenummer: PCT/EP2013/075831
(87) Internationale Veröffentlichungsnummer: WO 2015/082020

(56) Entgegenhaltungen:
- EP-A2- 1 675 165
- WO-A1-2010/023935
- WO-A1-2013/076874
- US-A1- 2010 139 836

## Beschreibung

Die vorliegende Erfindung betrifft ein Verfahren zum Ausrichten und Kontaktieren eines ersten Substrats mit einem zweiten Substrat nach Anspruch 1 sowie eine korrespondierende Vorrichtung nach Anspruch 7. Die Miniaturisierung von elektronischen Schaltkreisen, wie beispielsweise Mikrochips oder Speicherbausteinen sowie Mikromechanik- und Mikrofluidbauteilen schreitet seit Jahrzehnten unaufhörlich voran. Um die Dichte dieser funktionellen Gruppen weiter zu erhöhen, wurde vor einigen Jahren mit deren Stapelung begonnen. Die funktionellen Gruppen werden dazu auf einem Substrat, beispielsweise einem Wafer, hergestellt. Die Wafer werden dann zueinander ausgerichtet und miteinander verbondet, was in einigen wenigen Prozessschritten zu einer großen Ausbeute und vor allem einer hohen Dichten übereinander gestapelten funktionellen Gruppen führt. Die funktionellen Gruppen unterschiedlicher Wafer besitzen meistens auch unterschiedliche Funktionalität, So kann es sich bei den funktionellen Gruppen eines ersten Wafers um Mikrochips handeln, während es sich bei den funktionellen Gruppen des zweiten Wafers um Speicherchips handelt. Vor dem eigentlichen Verbindungsvorgang erfolgt eine Ausrichtung der Wafer zueinander. Je kleiner die funktionellen Gruppen auf den Wafern sind, desto genauer muss der Ausrichtungsprozess zweier Wafer zueinander sein, um die notwendige Genauigkeit und einen entsprechend geringen Ausschuss zu erzielen.

Die Genauigkeit, mit der zwei Wafer zueinander ausgerichtet werden können, hängt entscheidend von den optischen und den mechanischen Bauteilkomponenten der Ausrichtungsanlage, sowie deren Einsatz ab.

Bei den optischen Bauteilkomponenten ist vor allem darauf zu achten, dass die Vergrößerung, allen voran aber die Auflösung, hoch genug ist, um die Ausrichtungsmarken auf den Substraten so exakt wie möglich zu detektieren. Des Weiteren ist ein möglichst großer Tiefenschärfebereich bei entsprechend hoher Vergrößerung und Auflösung wünschenswert.

Bei den mechanischen Komponenten sind vor allem die Motoren und die Lager von entscheidender Bedeutung. Die Motoren müssen hohe Lasten beschleunigen, verschieben und abbremsen, müssen dabei aber auch eine möglichst genaue und vor allem reproduzierbare Positionsansteuerung zulassen. Um dies zu gewährleisten, sind spezielle Arten von Lagern notwendig. Die Lager sorgen für die weitestgehend reibungsfreie Lagerung der zu verschiebenden Last. Mit Vorzug wurden bis heute Luftlager verwendet, die eine kontaktlose Verschiebung zweier Bauteile zueinander erlaubten.

Vor allem in einer Vakuumumgebung kann es von Vorteil sein, auf möglichst viele Motoren und damit auch auf die notwendigen Lagerungen zu verzichten, um die Genauigkeit und Reproduzierbarkeit der verbleibenden Motoren zu erhöhen.

Im Stand der Technik existieren bereits Ausrichtungssysteme wie beispielsweise die in der AT405775B offenbart. Diese zeigen allerdings einige gravierende Nachteile. So sind die Verfahrwege der unteren und oberen Probenhalter in der Patentschrift AT405775B sehr lang, was zu einer entsprechend ungenauen Positionierung der beiden Substrate zueinander führen kann, wenn der eigentliche Prozess der Zusammenführung erfolgt.

Wünschenswert ist es außerdem, den Ausrichtungsprozess in einer Vakuumumgebung durchzuführen. Dementsprechend schwierig und problematisch ist die Verwendung der genannten Luftlager,

Daher wurde ein weiteres Ausrichtungssystem in der Druckschrift PCT/EP2013/062473 offenbart. In dieser Druckschrift wird das Problem der langen Verfahrwege dadurch gelöst, dass die zueinander auszurichtenden Substrate sich seitlich entlang der Verbindungsachse zweier Markierungen bewegen. Die Optiken wurden im Gegensatz zur Ausführungsform in AT405775B nicht vor den Substraten sondern seitlich dazu angebracht, sodass sich die Verfahrwege drastisch reduzieren lassen. Durch die radikale Verkürzung der Verfahrwege kann die Ausrichtungsanlage in PCT/EP20I3/062473 gänzlich andere, vor allem für das Vakuum geeignete, Motoren und Lager verwenden. Aus der Druckschrift US 2010/139836 A1 ist eine Vorrichtung zur Ausrichtung von Substraten bekannt.

Aufgabe der vorliegenden Erfindung ist es daher, eine Vorrichtung und ein Verfahren zum Ausrichten und Kontaktieren von Substraten anzugeben, mit dem eine genauere und effizientere Ausrichtung und Kontaktierung von Substraten, insbesondere unter Vakuum, ermöglicht wird.

Diese Aufgabe wird mit den Merkmalen der Ansprüche 1 und 7 gelöst. Vorteilhafte Weiterbildungen der Erfindung sind in den Unteransprüchen angegeben.

Die Erfindung handelt gattungsgemäß von einer Vorrichtung und einem Verfahren, zwei Substrate, mit Vorzug zwei Wafer, bestmöglich, insbesondere in einer Vakuumumgebung, zueinander auszurichten und nach der erfolgten Ausrichtung zu kontaktieren.

Der Erfindung liegt dabei insbesondere der Gedanke zu Grunde, dass für die korrekte Ausrichtung zweier Substrate zueinander nur ein, insbesondere einziger, Probenhalter (erste Aufnahme zur Fixierung des ersten Substrats) mit mindestens drei Freiheitsgraden benötigt wird, während ein zweiter Probenhalter (zweite Aufnahme zur Fixierung des zweiten Substrats) mit Vorzug nur einen einzigen, dafür aber hochpräzisen Freiheitsgrad besitzt. Unter hochpräzisem Freiheitsgrad versteht man, dass der Motor zur Steuerung des Probenhalters den Probenhalter entsprechend präzise positionieren kann. Des Weiteren sieht die erfindungsgemäße Ausführungsform mindestens zwei Erfassungseinheiten vor, die nur über einen einzigen Freiheitsgrad in einer Z-Richtung verfügen.

Die X-Richtung, Y-Richtung und Z-Richtung verlaufen jeweils quer (insbesondere senkrecht) zueinander, so dass hierdurch insbesondere ein kartesisches Koordinatensystem gebildet wird.

Die erfindungsgemäße Ausführungsform reduziert somit die Anzahl an insgesamt benötigten Freiheitsgraden von an der Ausrichtung beteiligten Bauteilen, die zur hochpräzisen Ausrichtung zweier Substrate zueinander benötigt werden.

Erfindungsgemäß wird insbesondere ein Kalibrierungssubstrat, vorzugsweise zwei Kalibrierungssubstrate, verwendet, um eine Justierung der Erfassungseinheiten zu den Bewegungen der Substrate durch die Aufnahmen vorzunehmen.

Die erfindungsgemäßen Ausführungsformen zeigen vor allem eine neue und erfinderische Apparatur, mit der die Ausrichtung und Kontaktierung von Substraten erstmals mit hoher Präzision im Vakuum möglich ist.

Die Erfindung besteht aus einer Ausrichtungsanlage (Vorrichtung) mit mindestens vier Erfassungseinheiten, insbesondere Optiken, zwei Ausrichtungseinheiten (erste bzw. obere und zweite bzw. untere Aufnahme) mit jeweils einem Probenhalter und entsprechenden X-, Y- und Z-Translationseinheiten mit Motoren zur Bewegung der Optiken der Erfassungseinheiten und der Probenhalter. Die Ausrichtungskammer kann entweder zur Atmosphäre hin offen sein oder sich bevorzugt in einem evakuierbaren Raum befinden.

Befinden sich die Erfassungseinheiten außerhalb der Ausrichtungskammer, besitzt die Ausrichtungskammer entsprechende Fenster, durch welche die Erfassung hindurch erfolgt. Durch Positionierung der Optiken (oder allgemeiner: Erfassungseinheiten) innerhalb der Ausrichtungskammer werden durch die Fenster bedingte optische Fehler vermieden, die durch die Transmission des Strahls durch die Fenster entstehen könnten. Denkbar wäre beispielsweise eine Abweichung des Strahlengangs durch nicht plan geschliffene Fensterseiten, Intensitätsverlust, Absorption gewisser Wellenlängen, Brechungseffekte oder ein diffuseres Bild auf Grund der rauen Oberfläche der Fenster. Das Montieren der Optiken außerhalb der Ausrichtungskammer bringt aber auch Vorteile. Die Optiken sind leichter zugänglich und müssen nicht für Vakuumumgebungen ausgelegt sein. Des Weiteren müssen auch die Motoren, mit deren Hilfe die Optiken bewegt werden, nicht für den Vakuumbetrieb ausgelegt sein.

In einer ganz besonderen Ausführungsform ist das Fenster nicht beidseitig planar, sondern selbst als optisches Element ausgeführt, welches zur Verbesserung der Vergrößerung und/oder Auflösung der Strukturen innerhalb der Kammer aktiv beiträgt. Durch eine entsprechend hochpräzise Fertigung des Fensters können die Brechungseigenschaften des Fensters damit aktiv genutzt werden und den Strahlengang gezielt beeinflussen, anstatt den Strahlengang zu verfälschen bzw. abzuschwächen. Denkbar wäre beispielsweise, dass das Fenster selbst als bikonvexe, bikonkave, konvexekonkave oder konkav-konvexe Linse ausgeführt wird. Denkbar ist auch, dass der größte Teil des Fensters beidseitig planar ausgeführt ist und sich das eigentliche Linsenelement abgetrennt vom Rand im Inneren Teil des Fensters befindet.

Insbesondere besitzen mindestens zwei, mit Vorzug auf der gleichen Seite der Ausrichtungskammer, bevorzugt am unteren Rand, liegende Optiken nur einen einzigen Translationsfreiheitsgrad, nämlich entlang der z-Richtung, und sind daher insbesondere auf eine reine Linearbewegung beschränkt.

Die Substrate, mit Vorzug Wafer werden auf Probenhaltern fixiert. Die Probenhalter werden auf Aufnahmen montiert. Die Aufnahmen besitzen im Allgemeinen mehrere Translations- und/oder Rotationseinheiten, welche die Translation bzw. Rotation der Probenhalter und damit der Substrate, insbesondere der Wafer, gestatten. Es existieren bevorzugt genau zwei Aufnahmen, insbesondere eine erste oder obere Aufnahme und eine zweite oder untere Aufnahme.

Die obere Aufnahme besitzt mehrere Freiheitsgrade, mit Vorzug einen für die X-, einen für die Y-Richtung sowie insbesondere einen Freiheitsgrad der Rotation. Denkbar wären noch zwei weitere Rotationsfreiheitsgrade und/oder ein Translationsfreiheitsgrad in z-Richtung.

Die untere Aufnahme besitzt erfindungsgemäß genau einen Translationsfreiheitsgrad entlang der Z-Richtung. Durch den Verzicht auf andere Freiheitsgrade kann die untere Aufnahme eine hochgenaue und vor allem sehr genau reproduzierbare Positionsansteuerung eines Wafers in Z-Richtung bewirken.

Im weiteren Verlauf wird davon ausgegangen, dass sich die Komponenten, insbesondere die Aufnahmen, mit ausschließlich einem Translationsfreiheitsgrad immer an der Unterseite der erfindungsgemäßen Vorrichtung bzw. der Ausrichtungskammer befinden, während die über eine maximale Anzahl an Freiheitsgraden aufweisenden Komponenten, insbesondere Aufnahmen, sich an der Oberseite der Ausrichtungskammer befinden (bevorzugte Ausführung). Des Weiteren wird bei den Optiken zwischen der linken und der rechten Optik beziehungsweise gegenüberliegend anordenbaren Erfassungseinheiten unterschieden. Denkbar wäre allerdings auch, die Komponenten mit nur einem Freiheitsgrad an der Oberseite zu montieren, oder teilweise an Ober- und Unterseite.

Der erfindungsgemäße Ausrichtungsvorgang beginnt mit dem Laden eines ersten Kalibriersubstrats auf den Probenhalter der ersten, insbesondere der oberen Aufnahme. Das erste Kalibriersubstrat besitzt mindestens zwei Markierungen, an zwei zueinander gegenüberliegenden Seiten des Kalibriersubstrats.

In einem ersten Kalibriersschritt wird das erste Kalibriersubstrat solange nach links verfahren, bis sich seine linke Markierung im Sichtbereich der linken oberen und unteren Optik befindet. In diesem Kalibriersschritt befindet sich die linke untere Optik im Allgemeinen noch zu weit von der linken Markierung entfernt, um sie scharf darzustellen. Daher wird die linke untere Optik durch eine hochpräzise und vor allem reproduzierbare Verschiebung solange an die linke Markierung des Kalibriersubstrats angenähert, bis diese sich im Tiefenschärfebereich der linken unteren Optik befindet. Da die linke untere Optik auf Grund der auf die Z-Richtung beschränkten Bewegungsfreiheit nicht innerhalb einer horizontalen Ebene verschoben werden kann, wird die linke Markierung des Substrats durch eine Translationsbewegung des Kalibriersubstrats mittels der X- und Y-Translationseinheiten mit der optischen Achse der linken unteren Optik zur Deckung gebracht.

Die Bewegungen der Translationseinheiten sind als Erfassungsdaten exakt erfassbar und werden an eine Steuerungseinrichtung übertragen, die zur Steuerung der Komponenten der Vorrichtung dient.

In einem zweiten Kalibrierschritt wird die linke obere Optik so zur linken Markierung des Kalibriersubstrats orientiert, dass deren optische Achse so exakt wie möglich auf die linke Markierung ausgerichtet wird. Die linke obere Optik ist in dieser Position fixierbar. Die Z-Position der linken unteren Optik wird gespeichert, um sie später wieder an die gleiche Position bewegen zu können.

In einer bevorzugten Ausführungsform wird der Schnittpunkt der beiden gegenüberliegenden optischen Achsen bestimmt öder die beiden optischen Achsen, werden so ausgerichtet, dass sie sich in der Markierung schneiden.

Durch die Fokussierung der linken Markierung durch die linke obere und rechte untere Optik wird bevorzugt sichergestellt, dass sich die linke Markierung im Tiefenschärfebereich (korrekt eigentlich Schärfentiefebereich) der beiden Optiken befindet. Die beiden Tiefenschärfebereiche besitzen allerdings eine endliche Ausdehnung und lassen so einen Schnittpunktbereich offen, in dem sich der Schnittpunkt der optischen Achsen befindet. Durch Optiken mit entsprechend geringen Tiefenschärfebereichen lässt sich die Position des Schnittpunktes stark eingrenzen. Durch die Abnahme des Tiefenschärfebereichs steigt insbesondere auch die Auflösung der Optik, was sich ebenfalls positiv auf die Bestimmung der Markierung auswirkt.

Erfindungsgemäß wird die Optik insbesondere so gesteuert, dass die Position der Markierung in Bezug auf die optische Achse durch die Optik erkennbar, erfassbar und speicherbar ist. So ist es grundsätzlich erstrebenswert, dafür zu sorgen, dass die Markierung möglichst zentrisch und daher möglichst nahe zur optischen Achse zu liegen kommt oder sich zumindest innerhalb eines sich um die optische Achse befindlichen Bereichs aufhält. Eine perfekte Ausrichtung der optischen Achse zur Markierung könnte ein sehr zeitintensiver und daher in der Massenproduktion auch ein sehr teurer Prozess sein. Es ist daher bevorzugt, die Markierung nur in das Sichtfeld (engl.: field of view) der jeweiligen Optik zu bekommen und danach den x- und y- Abstand der Markierung in Bezug auf die optische Achse zu ermitteln und abzuspeichern.

Des Weiteren wird erfindungsgemäß insbesondere berücksichtigt, dass die verwendeten Bildschirmsensoren, mit denen das Bild der jeweiligen Optik, sowie die Optiken selbst, eine leichte, von der optischen Achse zum Rand hin zunehmende Verzerrung aufweisen und damit die aufgenommenen Bilder eine umso schlechtere Messung der Markierungsposition erlauben, je weiter die Markierung von der optischen Achse entfernt ist.

Daher wird die Markierung erfindungsgemäß insbesondere so schnell wie möglich, so nahe wie möglich an die optische Achse geführt, ohne das Zentrum der Markierung und die optische Achse perfekt zur Deckung zu bringen. Der Bereich, in dem sich eine Markierung bevorzugt aufhalten soll wird mit F' bezeichnet. Erfindungsgemäß sollte sich die Markierung damit zumindest im Sichtfeld F der Optik befinden, noch bevorzugter allerdings im Bereich F'.

Durch diesen bevorzugten Prozess, bei dem die optischen Achsen die linke Markierung möglichst genau, aber nicht exakt fixieren, wird ein linker Nullpunkt festgelegt, auf den man sich beziehen kann, obwohl sich die optischen Achsen nicht genau in der linken Markierung schneiden.

In einer ganz besonderen, aber schwer zu erreichenden, beziehungsweise aus Zeit- und Kostengründen nicht erstrebenswerten, Ausführungsform werden beide optischen Achsen exakt auf die linke Markierung zentriert. Der Schnittpunkt der beiden linken optischen Achsen liegt dann zumindest innerhalb der Tiefenschärfebereiche der beiden linken Optiken und mit Vorzug sogar exakt im Zentrum der linken Markierung. In diesem idealen Fall entspricht der linke Schnittpunkt vorzugsweise exakt dem linken Nullpunkt.

Die beiden gegenüberliegenden Erfassungseinheiten arbeiten somit insbesondere als Erfassungspaar zusammen. Die linke untere Optik kann nun wieder in eine Ausgangsposition gefahren werden, in der sie die Beladung des später in die Ausrichtungskammer eingebrachten unteren Substrats nicht behindert.
In einem dritten Kalibrierschritt wird das erste Kalibriersubstrat solange nach rechts gefahren, bis sich seine rechte Markierung im Sichtbereich der rechten oberen Optik und der rechten unteren Optik befindet. In diesem Kalibrierschritt befindet sich die untere rechte Optik zur Bewegung des Substrats bevorzugt von der rechten Markierung entfernt, so dass zunächst eine ungefähre Positionierung erfolgt. Anschließend wird die rechte untere Optik durch eine hochpräzise und vor allem reproduzierbare Verschiebung solange an die rechte Markierung angenähert, bis diese sich im Tiefenschärfebereich der rechten unteren Optik befindet. Da die rechte untere Optik nicht innerhalb einer horizontalen Ebene, also in X- und Y-Richtung, verschoben werden kann, wird die rechte Markierung durch eine Translationsbewegung des Kalibriersubstrats über die obere Translationseinheit an die optische Achse der rechten unteren Optik angenähert, im Idealfall, der aber wiederum aus Zeit- und/oder Kostengründen nicht notwendigerweise wünschenswert ist, zur Deckung gebracht.

In einem vierten Kalibrierschritt wird die rechte obere Optik so zur rechten Markierung des Kalibriersubstrats orientiert wie bei der Kalibrierung der linken Optiken die obere linke Optik zur linken Markierung orientiert wurde. Primär ist es wiederum nur von Bedeutung, dass sich die rechte Markierung im Sichtfeld der rechten oberen Optik befindet. Mit Vorzug sollte sich die rechte Markierung wieder so nahe wie möglich an der optischen Achse der rechten oberen Optik befinden, um mögliche Messungenauigkeiten der Positionsbestimmung durch mögliche Verzerrungen des Bildsensors und/oder der Optik zu minimieren. Es ist gemäß einer Ausführungsform vorgesehen, die rechte Markierung und die optische Achse der rechten oberen Optik vollständig zur Deckung zu bringen.

Die rechte obere Optik wird in dieser Position fixiert und muss unter idealen Umständen bis zur Ausrichtung nicht mehr bewegt werden. Die Z-Position der rechten unteren Optik wird gespeichert (Erfassungsdaten), um sie später wieder an die exakt gleiche Position bewegen zu können.

Durch diesen bevorzugten Prozess, bei dem die optischen Achsen die linke Markierung möglichst genau, aber nicht exakt fixieren, wird ein linker Nullpunkt festgelegt, auf den man sich beziehen kann, obwohl sich die optischen Achsen nicht genau in der linken Markierung schneiden.

In einer ganz besonderen, aber schwer zu erreichenden, beziehungsweise aus Zeit und Kostengründen nicht erstrebenswerten, Ausführungsform werden beide optischen Achsen exakt auf die rechte Markierung zentriert. Der Schnittpunkt der beiden rechten optischen Achsen liegt dann zumindest innerhalb der Tiefenschärfebereiche der beiden rechten Optiken und mit Vorzug sogar exakt im Zentrum der rechten Markierung. In diesem idealen Fall entspricht der rechte Schnittpunkt vorzugsweise exakt dem rechten Nullpunkt.
Die beiden gegenüberliegenden Erfassungseinheiten arbeiten somit insbesondere als Erfassungspaar zusammen. Die rechte untere Optik kann nun wieder in eine Ausgangsposition gefahren werden, in der sie die Beladung des später in die Ausrichtungskammer eingebrachten unteren Substrats nicht behindert.

Mit diesen vier Kalibrierschritten ist die Kalibrierung der optischen Achsen der beiden Erfassungspaare abgeschlossen und die Tiefenschärfebereiche der Markierungen sind bekannt (Erfassungsdaten). Diese lassen sich auf die, insbesondere in den Abmessungen mit dem ersten Kalibriersubstrat ähnlichen, Substrate übertragen/umrechnen.

Bevorzugt werden die beiden optischen Achsen so ausgerichtet, dass sie sich in der späteren Bondebene schneiden. Da, wie bereits erwähnt, die exakte Festlegung des Schnittpunktes nur mit größeren Zeitaufwand möglich ist, erfolgt die Ausrichtung erfindungsgemäß zumindest so, dass die spätere Bondebene innerhalb der Tiefenschärfebereiche der Optiken liegt, wenn sie sich in jenen Positionen befinden, die durch den vorhergehenden Kalibriervorgang festgelegt wurden.

Bevorzugt werden die Optiken bei der Fokussierung einer Markierung eines Testsubstrats durch die obere und untere Optik so fokussiert, dass die Markierung (wie in den Kalibrierschritten weiter oben bereits ausführlich erwähnt) zu den beiden Optiken exakt zentriert ist. Erscheint sie beiden Optiken zentriert, sind beide Optiken exakt auf die Markierung ausgerichtet, so dass sich der Schnittpunkt der Optiken in der Markierung trifft.

Soweit eine der beiden Optiken die Markierung nicht zentrisch erfasst, wird ein Offset zwischen der Markierung und der optischen Achse von einer Soft-, Firm- oder Hardware gespeichert und kann so für spätere Umrechnungen verwendet werden. Speichert also eine entsprechende Soft-Firm- oder Hardware den Abstand zwischen den Schnittpunkten der optischen Achsen in der späteren Bondebene, kann auf einen exakten Schnittpunkt der optischen Achsen in der späteren Bondebene verzichtet werden und der Offset wird verwendet, um die beiden Substrate dennoch exakt zueinander auszurichten zu können.

Die unteren Optiken können entsprechend auf ihre gespeicherten Z-Positionen gefahren werden. Unter idealen Umständen muss diese Kalibrierung nur ein einziges Mal durchgeführt werden. Sollten allerdings Veränderungen am System vorgenommen werden, beispielsweise der Austausch einer oder mehrere Optiken, der Austausch mechanischer Teile oder vielleicht sogar nur eine Reinigung der Ausrichtungskammer, kann es notwendig werden, eine erneute Kalibrierung vorzunehmen. Insbesondere ist die Kalibrierung immer dann vorzunehmen, wenn eine Verschiebung des Schnittpunkts der optischen Achsen der linken bzw. rechten Seite erfolgt ist bzw. festgestellt wird.

Als nächstes erfolgt die Kalibrierung zwischen den oberen Optiken und einem zweiten, mit mehreren Markierungen (anders ausgedrückt: eine Markierungsmatrix) versehenen, Kalibrierungssubstrat, insbesondere um die X-Y-Bewegung der Translationseinheiten der ersten Aufnahme und/oder der Translationseinheiten der ersten Erfassungseinheiten zu erfassen und diese entsprechend zu kalibrieren.

Im weiteren Verlauf wird nicht mehr zwischen der exakten Justierung einer optischen Achse auf eine Markierung einerseits und der Annäherung zwischen der optischen Achse und der Markierung andererseits unterschieden, so wie das in den vorherigen Absätzen getan wurde. Jede der beiden Methoden zur Bestimmung der Position einer Markierung ist erfindungsgemäß möglich. Um die erfindungsgemäßen Ausführungsformen möglichst einfach zu halten, wird im weiteren Verlauf nur mehr von einer exakten Erfassung einer Markierung gesprochen werden. Die oben offenbarten Merkmale gelten analog für die folgenden Ausführungsformen. In einem ersten Kalibrierungsschritt verfährt das zweite Kalibrierungssubstrat unter die linke obere Optik, bis eine der Markierungen genau zentrisch zur optischen Achse der linken oberen Optik liegt. Danach erfolgt eine Fixierung des zweiten Kalibrierungssubstrats durch die obere Aufnahme, so dass diese während der nächsten Kalibrierungsschritte an derselben X-Y-Position verbleibt.

In einem zweiten Kalibrierungsschritt fährt die obere linke Optik mittels der X- und Y-Translationseinheiten der Erfassungseinheit die Markierungen der Markierungsmatrix an der linken Seite des zweiten Kalibrierungssubstrats ab und positioniert die linke obere Optik oberhalb einer jeden Markierung so, dass die aktuell angesteuerte Markierung zentrisch zur optischen Achse der oberen linken Optik angeordnet ist.

Die Markierungen der Markierungsmatrix des zweiten Kalibrierungssubstrats sind insbesondere durch einen Abscheideprozess erzeugt und besitzen einen hochgenauen, insbesondere äquidistanten und/oder genau bekannten, Abstand zueinander. Die Abstände zwischen den Markierungen der Markierungsmatrix sind kleiner als 100 µm, mit Vorzug kleiner als 10 µm, mit größerem Vorzug kleiner als 1 µm, mit größtem Vorzug kleiner als 100 nm. Die Abweichung bzw. ein Fehler der Abstände der Markierungen der Markierungsmatrix ist insbesondere kleiner als die Auflösungsgrenze und/oder die Genauigkeit der Optikmotoren der linken oberen Optik.

Die X-Y-Positionen der Steuereinheiten werden als Erfassungsdaten gespeichert, insbesondere von der zentralen Steuerungseinrichtung. Diese setzt sie mit dem für die entsprechende Markierung hinterlegten Wert in Relation. Dadurch erhält man zwei Positionskarten, eine ideale/vorgegebene Positionskarte mit idealen X- und Y-Positionen und eine dazu korrelierbare, reale Positionskarte, welche die realen X- und Y-Koordinaten (bzw. -Positionen) der linken oberen Optik angibt. Beide Positionskarten sind über eine bijektive Abbildung miteinander verknüpft/verknüpfbar. Durch Interpolation kann eine stetige Positionskarte erzeugt werden, um die realen X- und Y-Positionen zu ermitteln, welche die linke obere Optik oberhalb der idealen X- und Y- Positionen anfährt.

In einem dritten Kalibrierungsschritt verfährt das zweite Kalibrierungssubstrat unter die rechte obere Optik, bis eine der Markierungen genau zentrisch zur optischen Achse der rechten oberen Optik liegt. Danach erfolgt eine Fixierung des zweiten Kalibrierungssubstrats durch die obere Aufnahme, so dass diese während der nächsten Kalibrierungsschritte an derselben X-Y-Position bleibt.

Ein vierter Kalibrierungsschritt für die obere rechte Optik entspricht übertragen auf die rechte Seite dem zweiten Kalibrierungsschritt.

Ein letzter, erfindungsgemäßer Kalibrierungsschritt betrifft die z-Translationseinheit der unteren Aufnahme. Erfindungsgemäß ist die untere Aufnahme insbesondere mit nur einem Translationsfreiheitsgrad in z-Richtung versehen. Hierdurch wird eine hochpräzise Führung der unteren Aufnahme gewährleistet. Soweit beim Verfahren der unteren Aufnahme entlang der z-Richtung eine Abweichung in x- und/oder y-Richtung möglich ist, insbesondere durch Kippung der Bewegungsrichtung der unteren Aufnahme zur z-Achse oder durch Fehler in den Lagern, wird die Bewegung einer oder mehrerer Markierungen innerhalb der x-y Ebene der unteren Aufnahme gemäß einer bevorzugten Ausführungsform der Erfindung beobachtet. Insbesondere wird eine Verschiebung der unteren Aufnahme in x- und/oder y-Richtung an einer oder mehreren Markierungen als Funktion der Position entlang der z-Richtung ermittelt. Insbesondere wird die Funktion als lineare Funktion interpoliert. uf diese Weise ist in der Steuerungseinrichtung bzw. der Soft-, Firm- oder Hardware bekannt, um welchen Weg x- und/oder y sich ein Substrat verschiebt, wenn es über einen Weg z- Verfahren wird.

In einer ersten, Ausführungsform bleibt die beobachtete Markierung über den gesamten Weg z immer im Sichtfeld der Optik und in deren Tiefenschärfeberich. Das ist für nennenswerte Verfahrwege in z-Richtung allerdings nur dann möglich, wenn der Tiefenschärfeberiech entsprechend groß ist. Dies wäre, wenn überhaupt, nur mit Optiken mit einer geringen Vergrößerung und Auflösungsfähig möglich.

In einer zweiten, bevorzugten Ausführungsform wird die obere Optik mit dem Substrat entlang der z-Achse mitbewegt. Da die oberen Optiken erfindungsgemäß insbesondere auch über eine z-Translationseinheit verfügen, ist das von Vorteil. Dieser Kalibrierschritt wird bevorzugt vor allen anderen, oben beschriebenen Kalibrierungsschritten durchgeführt, damit die Optiken bei den nachfolgenden Kalibrierungsschritten nicht mehr in z-Richtung bewegt werden müssen.

Des Weiteren ist es erfindungsgemäß denkbar, dass die obere Optik und das Substrat mehrmals entlang der positiven und negativen z-Richtung verschoben werden und man die optimale Funktion durch Mittelung mehrerer solcher Durchläufe bestimmt.

In einer dritten, noch effizienteren und bevorzugteren Ausführungsform wird ein Kalibriersubstrat mit mindestens vier, insbesondere genau vier, Markierungen verwendet. Zwei Markierungen auf der Oberseite, jeweils einmal auf der linken und einmal auf der rechten Seite, sowie zwei Markierungen auf der Unterseite, ebenfalls jeweils einmal auf der linken und einmal auf der rechten Seite des Kalibriersubstrats.

Das Kalibriersubstrat besitzt eine exakt bekannte oder vermessene Dicke. Die Dicke ist zumindest in der Nähe der Markierungen genauestens bekannt. Die Dicke des Kalibriersubstrats ist dabei zumindest in der Nähe der Markierungen genauer bekannt als 100µm, mit Vorzug genauer bekannt als 10µm, mit größerem Vorzug genauer bekannt als 1µm, mit größtem Vorzug genauer bekannt als 100nm, mit allergrößtem Vorzug genauer bekannt als 10nm, am bevorzugtesten genauer bekannt als 1nm.

Soweit die sich jeweils gegenüberliegenden Markierungen zueinander in x- und/oder y-.Richtung verschoben sind, Wird der Relativabstand in x- und y-Richtung zweier sich gegenüberliegender Markierungen vermessen. Der Fehler ist dabei insbesondere geringer als 100 µm, mit Vorzug kleiner als 10µm, mit größerem Vorzug kleiner als 1µm, mit größtem Vorzug kleiner als 100nm, mit allergrößtem Vorzug kleiner als 10nm, am bevorzugtesten kleiner als 1nm.

Um die Abweichung der z-Translationseinheit entlang der x- und/oder y-Richtung entlang eines vorgegebenen Weges zu bestimmen, wird im Gegensatz zu den beiden vorher erwähnten erfindungsgemäßen Ausführungsform die obere Optik insbesondere auf die obere Markierung fokussiert. Danach wird die z-Translationseinheit in einer als Teilkalibrierschritt bezeichneten Bewegung über eine Strecke an die obere Optik angenähert, welche der Dicke des Kalibrierungssubstrats entspricht. Während der Annäherung kann die Verschiebung der z-Translationseinheit in x- und/oder y-Richtung durch die Verschiebung der oberen (und für den Fall, dass sich während des Prozesses auch die untere Markierung im Tiefenschärfebereich befindet, durch die untere) Markierung vermessen werden. Nachdem die obere Optik die untere Markierung fokussiert, verfährt die Optik solange, bis sich die obere Markierung wieder im Fokus befindet. Da sich der relative Abstand der beiden Markierungen in x- und/oder y-Richtung niemals ändert, kann die obere Optik nach der Verschiebung in z-Richtung wieder auf die gleiche Position relativ zur oberen Markierung eingestellt werden, in der sie sich vor diesem Teilkalibrierschritt befunden hat. Eine möglicherweise durch die z-Bewegung der oberen Optik entstehende x- und/oder y- Verschiebung wird irrelevant für die Bestimmung der x- und/oder y- Verschiebung der Translationseinheit, soweit die Optik vor jedem neuen Teilkalibrierschritt erneut bezüglich der oberen Markierung positioniert wird. Dieser Teilkalibrierschritt kann über eine beliebige Strecke wiederholt werden.

Mit anderen Worten bewegen sich die obere Optik und das Kalibrierungssubstrat Schritt für Schritt und abwechselnd entlang des zu vermessenden Weges, wobei die Optik vor einem neuen Kalibrierungsschritt immer wieder an den Markierungen des Kalibrierungssubstrats ausgerichtet wird.

Erfindungsgemäß denkbar ist auch genau der umgekehrte Vorgang, nämlich dass die obere Optik zuerst auf die untere Markierung fokussiert wird und das Kalibrierungssubstrat danach von der oberen Optik weg bewegt wird. Die obere Optik folgt dann nach erfolgt z-Verschiebung des Kalibrierungssubstrats dem selbigen.

Der Kalibrierungsschritt ist besonders effizient, wenn die obere und untere Markierung während der Bewegung des Kalibrierungssubstrats immer innerhalb des Tiefenschärfebereichs der oberen Optik angeordnet werden. Das Kalibrierungssubstrat ist bei dieser erfindungsgemäßen Ausführungsform transparent. Das Kalibrierungssubstrat wird außerdem so dünn wie möglichgewählt, aber so dick wie nötig, um eine Durchbiegung möglichst zu verhindern. Das Kalibrierungssubstrat besitzt insbesondere eine Dicke kleiner als 2000 µm, mit Vorzug kleiner als 1000µm, mit größerem Vorzug kleiner als 500µm, mit größtem Vorzug kleiner als 100µm. Die Kalibrierung der Abweichung der z-Translationseinheit in x- und y-Richtung ist besonders effizient, wenn die obere linke Optik die erwähnte Vermessung auf der linken und die obere rechte Optik, insbesondere zur selben Zeit, die Vermessung auf der rechten Seite durchführt.

Hat man auch diesen Kalibrationsschritt abgeschlossen, ist eine exakte Vorhersage möglich, um wie viel sich ein Substrat bei einer Bewegung in positiver oder negativer z-Richtung in x- und/oder y-Richtung verschiebt.

Nachdem alle Kalibrierungsvorgänge mit den Kalibrierungssubstraten abgeschlossen worden sind, kann die Prozessierung der Substrate beginnen. Im weiteren Verlauf wird ein bevorzugter face-to-face Ausrichtungsprozess an einer vorher korrekt kalibrierten erfindungsgemäßen Ausführungsform dargestellt. Bei einem face-to-face Ausrichtungsprozess befinden sich die Markierungen an den miteinander zu verbondenden Kontaktflächen der beiden Substrate. Der face-to-face Ausrichtungsprozess soll als ein beispielhafter Ausrichtungsprozess dienen. Er ist auch ein geeignetes Beispiel, da er den kompliziertesten Ausrichtungsprozess darstellt. Das liegt daran, dass in einem face-to-face Ausrichtungsprozess die Markierungen während der Annäherung der Substrate für die Optiken nicht zugänglich sind, die Substrate also quasi blind angenähert werden.

Denkbar wäre auch die Durchführung eines back-to-back, eines face-to-back und eines back-to-face Prozesses. Beim back-to-back Prozess befinden sich die Ausrichtungsmarken immer an den Außenseiten der Substrate. Die Verwendung der erfindungsgemäßen Ausführungsform für einen derartigen Ausrichtungsprozess ist zwar grundsätzlich denkbar, stellt allerdings keine Herausforderung dar, da die Markierungen zu jedem Zeitpunkt vollständig zugänglich sind, insbesondere während der Annäherung der beiden Substrate zueinander. Damit ist durch die entsprechend positionierten Optiken eine in-situ Vermessung der Markierungen während des Ausrichtungsprozesses denkbar. Bei dem back-to-face bzw. face-to-back Ausrichtungsprozess handelt es sich um jene Ausrichtungsprozesse, bei welchen die Markierung eines Substrats verdeckt wird, da sie sich in Richtung des späteren Bondinterfaces befindet, während die zweite Markierung kontinuierlich beobachtbar ist.

In einem ersten erfindungsgemäßen Prozessschritt wird ein erstes Substrat in die Ausrichtungskammer auf die erste Aufnahme geladen und insbesondere an dieser fixiert. Die Orientierung des Substrats erfolgt entweder vor dem Laden in einem externen Vorausrichter (engl.: Prealigner) oder innerhalb der Kammer durch einen internen Ausrichter. Dabei wird das Substrat bezüglich seiner typischen Merkmale, wie beispielsweise einer flachen Seite (engl.: flat) oder einer Kerbe (engl. Notch), positioniert und orientiert.

Danach verfährt die Translationseinheit der ersten Aufnahme das geladene Substrat solange nach links, bis die linke Markierung sich im Sichtfeld (engl.: field of view, FOV) der linken unteren Optik befindet. Um die linke Markierung scharf abbilden zu können, muss sich diese im Tiefenschärfebereich der linken Optik befinden. Die linke Optik wurde im vorhergehenden Kalibrierungsprozess auf den ungefähren Tiefenschärfebereich, insbesondere bezogen auf das ähnlich, vorzugsweise identisch, dimensionierte Kalibriersubstrat, kalibriert. Die gespeicherte Z-Position der linken unteren Optik kann verwendet werden, um die linke untere Optik in die exakt gleiche Z-Position zu bewegen. Die Annäherung der linken unteren Optik kann insbesondere zeitgleich mit der Bewegung des oberen geladenen Substrats erfolgen, um Zeit zu sparen und den Prozess zu optimieren.

Soweit sich die linke Markierung des oberen Substrats nach dem Aufenthalt im Tiefenschärfebereich der linken unteren Optik nicht genau in der optischen Achse der linken unteren Optik befinden, werden beide optischen Achsen durch eine präzise Steuerung des ersten Substrats, insbesondere mit der oberen Aufnahme, miteinander zur Deckung gebracht. Danach kann eine Abspeicherung der Encoderpositionen (Erfassungsdaten) der oberen Aufnahme für alle Freiheitsgrade erfolgen. Die aktuellen Encoderpositionen werden damit eindeutig der linken oberen Markierung zugeordnet.

Unter einer Encoderposition wird erfindungsgemäß jede Größe verstanden, welche Auskunft über die Position und/oder Orientierung eines Gegenstandes, insbesondere eines Substrats, liefert. Darunter fallen beispielsweise die Motorpositionen eines Motors, die direkt aus der Motörenelektronik ausgelesen werden, die Position eines Gegenstandes die durch ein Interferenzverfahren bestimmt werden, die Position eines Gegenstandes, die mittels optischer Messsysteme wie Interferometer oder dgl. ermittelt wurde, oder die Position die über Längenmaßstäbe ermittelt wurde. Unter Position eines Gegenstandes versteht man beispielsweise die mittels eines Interferometers hochpräzise vermessene Position der Translationseinheiten, an denen ein Substrat statisch fixiert wurde.

In einem zweiten erfindungsgemäßen Prozessschritt wird der erste Prozessschritt analog für die rechte Markierung des ersten Substrats auf der rechten, insbesondere genau gegenüberliegenden, Seite durchgeführt. Der zweite Prozessschritt kann auch vor dem ersten ausgeführt werden.

Nach diesen Prozessschritten sind für beide Markierungen des oberen Substrats alle Encoderpositionen bekannt. Als Bezugspunkt kann entweder der linke Nullpunkt, der rechte Nullpunkt oder ein, aus linkem und rechtem Nullpunkt berechneter, Nullpunkt dienen. Mit Vorzug wird allerdings einer der physikalischen, durch den Schnittpunkt der optischen Achsen der linken bzw. rechten Optiken definierten, Nullpunkte verwendet.

In einem dritten erfindungsgemäßen Prozessschritt wird ein weiteres, zweites Substrat in die Ausrichtungskammer auf den Probenhalter der zweiten Aufnahme geladen und insbesondere an diesem fixiert, insbesondere zentrisch. Danach verfährt eine der Translationseinheiten der oberen Aufnahme das erste Substrat so weit nach rechts, dass die linke obere Optik freie Sicht auf die linke Markierung des eben geladenen, zweiten (unteren) Substrats besitzt. Die obere linke Optik sollte dabei mit Vorzug bereits so positioniert sein, dass sie die linke Markierung des unteren Substrats im Sichtbereich hat. Das untere Substrat wird durch Translationseinheit der unteren Aufnahme solange angehoben, bis sich die linke Markierung im Tiefenschärfebereich der oberen linken Optik befindet. Danach erfolgt die Verschiebung der oberen linken Optik in X- und/oder Y-Richtung, um die optische Achse der linken oberen Optik mit der linken Markierung des unteren Substrats zur Deckung zu bringen. Die Verschiebung der oberen linken Optik in Bezug auf den linken Nullpunkt wird gespeichert (Erfassungsdaten).

In einem vierten erfindungsgemäßen Prozessschritt wird der dritte Prozessschritt analog für die rechte Markierung des zweiten Substrats auf der rechten, insbesondere genau gegenüberliegenden, Seite durchgeführt. Der vierte Prozessschritt kann auch vor dem dritten Prozessschritt ausgeführt werden.

In einem fünften erfindungsgemäßen Prozessschritt werden alle ermittelten Positionen aller Freiheitsgrade der ersten und zweiten Aufnahme, insbesondere der oberen und der unteren Aufnahme, als Erfassungsdaten verwendet, um die beiden Substrate bezüglich deren linker und rechter Markierungen miteinander auszurichten. Der Ausrichtungsprozess selbst erfolgt dabei insbesondere unabhängig von den Erfassungseinheiten, also ohne weitere Verwendung der Optiken. Im Allgemeinen werden sämtliche Translationseinheiten und/oder Rotationseinheiten der unteren und/oder oberen Aufnahme verwendet, um die beiden Substrate zueinander auszurichten.

Eine erfindungsgemäß denkbare Ausrichtungsreihenfolge wäre wie folgt. Zuerst wird das obere Substrat geladen. Das Substrat wird solange verfahren, bis die linke und rechte Markierung von der unteren linken bzw. der unteren rechten Optik zentrisch fokussiert wurde. Die Encoderpositionen werden entsprechend gespeichert. Danach erfolgen die Ladung des unteren Substrats und die Fokussierung der linken bzw. rechten Markierung mit Hilfe der oberen Optiken. Da das untere Substrat nicht in x- und/oder y-Richtung bewegt werden kann, müssen sich die Markierungen zumindest in den Sichtfeldern (engl.: field of view) der oberen linken bzw. oberen rechten Optik befinden. Da man den Abstand der Markierungen zu den optischen Achsen bestimmen kann, die Encoderpositionen des oberen Substrats bezüglich der optischen Achsen exakt bestimmt wurden und das obere Substrat verfahrbar ist, kann das obere Substrat jederzeit auf die notwendige x- und/oder y-Position verfahren werden, sodass die Markierungen des oberen Substrats exakt über den Markierungen des unteren Substrats positioniert werden. Mit Vorzug ist der z-Abstand zwischen den beiden Substrate während dieses Vorganges bereits so gering wie möglich.

In einem sechsten erfindungsgemäßen Prozessschritt erfolgt die Kontaktierung der beiden Substrate. Mit Vorzug erfolgt die Kontaktierung, insbesondere ausschließlich, durch ein Anheben des unteren Substrats durch die Translationseinheit der unteren Aufnahme. Da die untere Aufnahme nur über eine einzige, hochgenaue Translationseinheit verfügt und daher das untere Substrat ausschließlich in Z-Richtung bewegt wird, insbesondere werden kann, erfolgt während der Annäherung keine oder zumindest nur eine vernachlässigbare X- und/oder Y- Abweichung. Die Abweichung des unteren Substrats in x- bzw. y-Richtung während des Annäherungsprozesses an das obere Substrat in z-Richtung ist dabei kleiner als 10µm, mit Vorzug kleiner als 1 µm, mit größerem Vorzug kleiner als 100 nm, mit größtem Vorzug kleiner als 1 0nm, mit allergrößtem Vorzug kleiner als 1 nm.

In einem siebten erfindungsgemäßen Prozessschritt erfolgt eine Fixierung des oberen mit dem unteren Substrat (insbesondere Bonding). Denkbar wäre eine mechanische, elektrostatische, magnetische, elektrische oder mittels Folien oder Klebern durchgeführte Fixierung der beiden Substrate zueinander. Besonders bevorzugt wäre auch ein Si-Si bzw. SiO₂-SiO₂ Direktbond zwischen den beiden Substraten. Die Substrate können entweder zueinander oder in Bezug auf den unteren Probenhalter fixiert werden. Mit besonderem Vorzug wird der Probenhalter allerdings nur zur Substrataufnahme während des Ausrichtungsprozesses verwendet und es erfolgt eine Fixierung der beiden Substrate zueinander, sodass der Probenhalter nach der Entfernung des Substratstapels in der Ausrichtungsanlage verbleibt und damit sofort für den nächsten Ausrichtungsprozess zur Verfügung steht.

Mit besonderem Vorzug wird die in der Patentschrift PCT/EP2013/056620 aufgezeigte Methode verwendet, um die Substrate magnetisch miteinander zu fixieren. Durch diese besondere Fixierungsmethode ist es mit besonderem Vorzug möglich, auf einen schweren, teuren und schwer zu handhabenden Probenhalter zu verzichten bzw. einen Probenhalter in der Ausrichtungsanlage zu belassen um ihn nach der Entfernung des Substratstapels sofort wieder verwenden zu können.

In einer weiteren besonderen Ausführungsform wird mindestens ein Substrat auf einem Probenhalter in die erfindungsgemäße Ausführungsform geladen, sodass die Ausrichtung eines zweiten Substrats zu dem auf dem Probenhalter fixierten Substrat erfolgt und mit besonderem Vorzug beide Substrate bezüglich des Probenhalters fixiert werden. Durch diese Vorgehensweise können zwei Substrate zueinander ausgerichtet, zum Probenhalter fixiert und direkt (also auf dem Probenhalter fixiert) in eine weitere Prozesskammer transportiert werden. Mit besonderem Vorzug erfolgt ein Weitertransport in eine Bondkammer, in der dann ein Bondschritt, insbesondere mit einer Druckbeaufschlagung der beiden Substrate, durchgeführt wird.

Gemäß einem, insbesondere wesentlichen, Erfindungsaspekt ist vorgesehen, dass die Z-Positionierung aller Komponenten einer ausgewählten Seite, insbesondere der unteren oder der oberen Seite, mit extrem hoher Präzision und vor allem Wiederholbarkeit durchgeführt werden kann. Die Ansteuerung einer z-Position erfolgt mit einer Genauigkeit kleiner als 10µm, mit Vorzug kleiner als 1 µm, mit größerem Vorzug kleiner als 100 nm, mit größtem Vorzug kleiner als 10 nm. Das liegt vor allem daran, dass auf weitere Freiheitsgrade, welche zu einer negativen Beeinflussung der Genauigkeit und Wiederholbarkeit der Z-Positionierung führen könnten, verzichtet wird.

Unter Substraten werden in der Halbleiterindustrie verwendete Produkt- oder Trägersubstrate verstanden. Ein Trägersubstrat dient als Verstärkung des Funktionssubstrates (Produktsubstrat) bei den verschiedenen Bearbeitungsschritten, insbesondere beim Rückdünnen des Funktionssubstrates. Als Substrate kommen insbesondere Wafer, entweder mit Abflachung ("flat") oder Einkerbung ("notch"), in Frage.

Funktionale Bauteile der erfindungsgemäßen Vorrichtung wie Schlitten, Motoren, Optiken, Halterungen sind mit Vorzug in einem Gehäuse verbaut. Das Gehäuse ist insbesondere hermetisch zur Umgebung abschließbar. Das Gehäuse besitzt mit Vorzug einen Deckel, welcher den Zugang zu den funktionalen Bauteilen ermöglicht. Insbesondere ist an mindestens einer Seite des Gehäuses ein Schleusentor vorgesehen. Dem Schleusentor kann eine entsprechende Schleuse vor- und/oder nachgeschaltet sein. Bei Verwendung einer Schleuse vor und/oder nach dem Schleusentor kann man mit Vorzug im Gehäuse eine andere Atmosphäre einstellen als in der Umgebung des Gehäuses. Die Atmosphäre ist vorzugsweise eine Unterdruckatmosphäre.

Während eines erfindungsgemäßen Ausrichtungsvorganges beträgt der Druck im Inneren des Gehäuses der Ausrichtungskammer insbesondere gleich 1bar, mit Vorzug weniger als 10⁻¹ mbar, mit größerem Vorzug weniger als 10⁻³ mbar, mit größtem Vorzug weniger als 10⁻⁵ mbar, mit allergrößtem Vorzug weniger als 10⁻⁸ mbar.

Während eines erfindungsgemäßen Ausrichtungsvorganges beträgt der Druck außerhalb des Gehäuses gleich 1bar, mit Vorzug weniger als 10⁻¹ mbar, mit größerem Vorzug weniger als 10⁻³ mbar, mit größtem Vorzug weniger als 10⁻⁵ mbar, mit allergrößtem Vorzug weniger als 10⁻⁸ mbar.

Alle Substrate können entweder über ein Schleusentor oder den Deckel in den Innenraum eingebracht werden. Mit Vorzug werden die Substrate über das Schleusentor in den Innenraum transportiert.

In einer besonderen Ausführungsform erfolgt der Transport der Substrate bzw. des aus den zueinander ausgerichteten Substraten bestehenden Substratstapels aus dem Gehäuse mittels eines Roboters.

Die Genauigkeit, mit der die Erfassungsgeräte der Erfassungseinheiten einzeln bewegt werden können, ist besser als 1mm, mit Vorzug besser als 100µm, mit großem Vorzug besser als 10µm, mit größerem Vorzug besser als 1µm, mit noch größerem Vorzug besser-als 100nm, mit allergrößtem Vorzug besser als 10nm.

In der Ausrichtungseinheit befindet sich, insbesondere ausschließlich an der Oberseite, eine erste Aufnahme für eines der beiden Substrate. Auf der ersten Aufnahme befindet sich insbesondere ein Probenhalter als Bestandteil der ersten Aufnahme. Der Probenhalter besitzt mindestens drei, insbesondere sechs Freiheitsgrade, mindestens drei Freiheitsgrade der Translation entlang der X-, Y- und Z-Richtung, sowie gegebenenfalls drei Freiheitsgrade der Rotation um die X-, Y- und Z-Achse, im Folgenden mit den Winkeln Alpha, Beta und Gamma bezeichnet. Die Translationsfreiheitsgrade dienen der Verschiebung des Probenhalters und damit des Substrats innerhalb der durch die X- und die Y-Richtung aufgespannten X-Y Ebene sowie der Annäherung der beiden Substrate zueinander entlang der Z-Richtung. Die Rotationsmöglichkeit um die X-, Y- und Z-Achse dient erfindungsgemäß zur Durchführungen eines Keilfehlerausgleichs und/oder der Orientierung des Substrats. Bei den Rotationen um die X-, Y- und Z-Achse handelt es sich insbesondere um Rotationen mit geringen Rotationswinkeln, sodass man auch von einer Kippung sprechen könnte.

Erfindungsgemäß können Probenhalter als Aufnahmen für die Substrate insbesondere mit den folgenden unterschiedlichen Fixiermechanismen verwendet werden:
- Vakuumprobenhalter
- Elektrostatischer Probenhalter
- Probenhalter mit einer adhäsiven Oberfläche
- Probenhalter, die auf Venturi und Bernoullieffekten beruhen
- Magnetische Probenhalter
- Probenhalter mit mechanischen Fixierungen und/oder Klemmmechanismen

Bei der Verwendung der erfindungsgemäßen Ausführungsform in einer Vakuumumgebung werden Vakuumprobenhalter und/oder Venturi- und/oder Bernoulliprobenhalter nur eingeschränkt, im Extremfall gar nicht, verwendet.

Vor dem eigentlichen Ausrichtungsvorgang ist erfindungsgemäß eine Kalibrierung der Erfassungsmittel von Vorteil. Wie bereits erwähnt, sind zwei sich gegenüberliegende Optiken mindestens dahingehend zu kalibrieren, dass sich eine Markierung pro Seite zumindest in den Sichtfeldern der oberen und unteren Optik befindet, vorzugsweise innerhalb eines Bereichs der möglichst nahe an der optische Achse der oberen bzw. unteren Optik liegt.

In einer bevorzugten Ausführungsform, besteht das Ziel der Kalibrierung insbesondere darin, den Schnittpunkt der optischen Achsen zweier, jeweils gegenüberliegender Erfassungsgeräte in das Zentrum einer Markierung eines Kalibrierungssubstrats zu legen. Diese Kalibrierung erfolgt vorzugsweise getrennt für alle Erfassungsgeräte der Erfassungseinheiten.

Durch die Kalibrierung wird insbesondere sichergestellt, dass gegenüberliegende (obere und untere) Erfassungsgeräte einer Erfassungseinheit einen gemeinsamen Fokusbereich aufweisen.

In einer noch bevorzugteren Ausführungsform werden die optischen Achsen von gegenüberliegenden Erfassungsgeräten kollinear zueinander ausgerichtet. Hierzu weist mindestens eines der Erfassungsgeräte, insbesondere jeweils das obere, Rotationsfreiheitsgrade auf, vorzugweise durch Anordnung auf einem Goniometer.

Ein oder der Schnittpunkt der optischen Achsen der Erfassungsgeräte wird erfindungsgemäß insbesondere so angeordnet, dass die korrespondierenden Markierungen der auszurichtenden Substrate in der Erfassungsposition in X-, Y- und Z-Richtung in diesem Punkt zumindest fokussierbar und/oder anordenbar bzw. angeordnet sind. Durch diese Maßnahme werden die Verfahrwege erfindungsgemäß weiter minimiert.

Die Schnittpunkte der optischen Achsen befinden sich mit Vorzug in der Fokusebene bzw. zumindest im Tiefenschärfebereich der Optiken. Auflösung und Tiefenschärfebereich sind zwei miteinander konkurrierende Parameter. Je größer die Auflösung, desto kleiner der Tiefenschärfebereich und umgekehrt. Verwendet man also Optiken mit einem hohen Auflösungsvermögen, besitzen diese einen entsprechend geringen Tiefenschärfebereich. Dadurch müssen die Ausrichtungsmarken des oberen und unteren Substrats sich gleichzeitig innerhalb eines sehr kleinen Tiefenschärfebereichs aufhalten, um noch scharf abgebildet werden zu können. Erfindungsgemäß wird daher der Schnittpunkt der optischen Achsen im Tiefenschärfebereich der korrespondierenden Erfassungsgeräte angeordnet.

Erfindungsgemäß ist es von Vorteil, wenn die Erfassungsgeräte so kalibriert werden, dass die Kontaktflächen und/oder die Markierungen der Substrate in den Erfassungspositionen der jeweiligen Erfassungseinheiten innerhalb der Tiefenschärfebereiche angeordnet sind. Dadurch kann erfindungsgemäß auf eine Nachfokussierung verzichtet werden.

Die Steuerung der Bewegung der Substrate und/oder Erfassungsmittel erfolgt mittels einer, insbesondere softwaregestützten, Steuerungseinrichtung.

Durch die Erfindung ist es, insbesondere nach einer Kalibrierung des Systems, möglich, ein erstes Substrat auf eine erste Aufnahme (Probenhalter) und ein zweites Substrat auf eine zweite Aufnahme zu fixieren. Die erste Aufnahme und die in X- und Y-Richtung beweglichen, insbesondere der ersten Aufnahme räumlich zugeordneten, Erfassungseinheiten, fahren das erste Substrat, insbesondere symmetrisch, jeweils in unterschiedliche, separate, insbesondere seitlich gegenüberliegend zu der Ausrichtungseinheit angeordnete, Erfassungspositionen.

Der Erfindung liegt also vor allem der Gedanke zu Grunde, die für den Ausrichtungsprozess nötigen Erfassungsmittel so auszubilden, dass jeweils zwei aufeinander zu gerichtete Erfassungsgeräte, insbesondere an jeweils gegenüberliegenden Seite der Ausrichtungseinheit, die X-Y-Positionen von Markierungen der Substrate erfassen, wobei jeweils eine der Erfassungseinheiten in X- und Y-Richtung fixiert/unbeweglich ist. Insbesondere ist eines der Substrate, insbesondere das Substrat, welches räumlich den unbeweglichen Erfassungseinheiten zugeordnet (vorzugsweise zwischen diesen angeordnete) ist, ebenfalls in X- und Y-Richtung fixiert/unbeweglich. In dem erfindungsgemäßen Verfahren wird dadurch der Verfahrweg der beiden Substrate insgesamt minimiert.

Soweit sich im erfindungsgemäßen Verfahren eine der beiden Aufnahmen und/oder jeweils eine Erfassungseinheit jedes Erfassungspaares, insbesondere ausschließlich, entlang der Z-Achse bewegen, können Translationseinheiten mit einer sehr hohen Genauigkeit und Reproduzierbarkeit verwendet werden. Soweit ein Drift in einer X- und/der Y-Richtung erfolgt, ist dieser mit Vorteil erfindungsgemäß messbar und kompensierbar.

Erfindungsgemäß wird ein Abstand der Substrate in Z-Richtung vor der Erfassung bis zur Ausrichtung konstant eingestellt und/oder minimiert, insbesondere kleiner als 1cm, vorzugsweise kleiner als 1mm, noch bevorzugter kleiner als 100µm.

Der Vorteil der Erfindung liegt vor allem darin, dass die Vorrichtung auch im Vakuum betrieben werden kann. Durch die erfindungsgemäß verhältnismäßig kurzen Verfahrwege der oberen und/oder unteren Aufnahme und damit des ersten (unteren) und/oder zweiten (oberen) Substrats können mechanische Bauteile für Schlitten/Lager/Schrittmotoren verwendet werden, die vakuumtauglich sind. Damit ist es erstmals möglich, ein Bondmodul und ein Ausrichtungsmodul in einem Vakuumcluster, mit Vorzug einem Hochvakuumcluster, zu installieren und den Substrattransport von dem Aüsrichtungsmodul zum Bondmodul innerhalb eines evakuierbaren Bereiches durchzuführen, ohne das Substrat einer Atmosphäre aussetzen zu müssen.

Ein weiterer erfindungsgemäßer Vorteil liegt vor allem in der höheren Positioniergenauigkeit der beiden Substrate zueinander, die darauf zurückzuführen ist, dass eine der beiden Aufnahmen, insbesondere die untere Aufnahme, nur eine Translationseinheit besitzt und dadurch ein Fehler in der x- und/oder y- Richtung während der Annäherung an das zweite Substrat weitgehend unterdrückt wird. Das mechanische Spiel der Translationseinheit in x- und/oder y-Richtung kann dabei schon durch die Konstruktion weitgehend vernachlässigt werden.

Ein weiterer Vorteil liegt in der Verwendungsmöglichkeit von sichtbarem Licht. Die Ausrichtung zweier Substrate durch, an deren Bondseiten angebrachten, Markierungen könnte in vielen Fällen auch mit Hilfe von Infrarotlicht erfolgen. Reines Silizium absorbiert Infrarotlicht, insbesondere Infrarotlicht im nahen Infrarotbereich, beinahe überhaupt nicht. Das Problem besteht vor allem darin, dass nur in den wenigsten Fällen Substrate vorhanden sind, die zumindest im Bereich der Markierungen von reinem Silizium umgeben sind. In der Mehrzahl aller Fälle sind die Siliziumsubstrate mit den unterschiedlichsten Metallschichten bedampft worden. Metalle absorbieren die Infrarotstrahlung allerdings sehr gut und wirken daher als Barriere für das Infrarotlicht. Je höher die Packungsdichten der funktionalen Einheiten auf den Substrate wird, je mehr Metallschichten abgeschieden werden und je komplizierter entsprechende Substrate behandelt werden, desto unwahrscheinlicher ist die Verwendung von Infrarotoptiken für eine face-to-face Ausrichtung. Das erfindungsgemäße Verfahren erlaubt die Verwendung von Licht im sichtbaren Wellenlängenbereich. Mit besonderem Vorzug können damit auch wesentlich bessere Detektoren und optische Elemente verwendet werden. Die optischen Elemente für die Infrarotoptik reagieren meistens sehr sensitiv auf Umgebungsparameter wie Luftfeuchtigkeit, sind sehr spröde und müssen entsprechend kompakt verbaut werden. Dementsprechend hoch sind die Preise dieser optischen Elemente. Einer der Kernaspekte der erfindungsgemäßen Vorrichtung und des erfindungsgemäßen Prozesses besteht also darin, dass eine direkte Beobachtung der Oberfläche erfolgen kann und man beim Ausrichtungsprozess nicht auf die Transparenz von Wafern angewiesen ist.

Auf die Verwendung von Transmissionstechniken kann daher erfindungsgemäß verzichtet werden. Des Weiteren können alle Substrate, auch für den breiten Bereich des elektromagnetischen Spektrums opake Substrate, vermessen werden, da die Markierungen auf den Oberflächen auffindbar sind, ohne das Substrat durchleuchten zu müssen. Dennoch ist es denkbar, sämtlichen bekannten und zweckdienlichen Wellenlängenbereiche des elektromagnetischen Spektrums zu verwenden um die Erkennung der Markierungen vorzunehmen. Insbesondere wird die Verwendung von Infrarotlicht, mit besonderem Vorzug nahes Infrarotlicht, offenbart auch wenn dessen Verwendung von sekundärer Bedeutung ist.

In allen Figuren werden die Aufnahmen immer innerhalb des Gehäuses dargestellt. Denkbar wäre natürlich auch, dass die Aufnahmen, und damit die Translations- und/oder Rotationseinheiten, sich außerhalb des Gehäuses befinden und durch entsprechende Vakuumdurchführungen die Probenhalter, die sich innerhalb des Gehäuses befinden, steuern. Dasselbe gilt auch für die Erfassungsmittel. In der optimalsten, aber technisch natürlich schwer zu realisierenden, Ausführungsform würden sich nur die beiden zueinander auszurichtenden Substrate im Vakuum befinden.

Die erfindungsgemäße Ausführungsform wird mit Vorzug in einem Vakuumcluster, mit noch größerem Vorzug in einem Hochvakuumcluster, mit größtem Vorzug in einem Ultrahochvakuumcluster, zusammen mit anderen Modulen verwendet. Bei den anderen Modulen kann es sich beispielsweise um eines oder mehrere der folgenden Module handeln
- Heizmodul
- Kühlmodul
- Belackungsmodul
- Bondmodul
- Debondmodul
- Inspektionsmodul
- Laminierungsmodul
- Oberflächenbehandlungsmodul
- Plasmamodul

In einer besonderen Ausführungsform werden die zueinander ausgerichteten Substrate mit einer in Patentschrift PCT/EP2013/056620 erwähnten Methode zueinander geklemmt, auf die insofern Bezug genommen wird. Die Klemmmethode verwendet kleine Magnetkörper zur schnellen, effizienten und leichten Fixierung der beiden, zueinander ausgerichteten und in Kontakt gebrachten Substrate. Die beiden Substrate können auch über molekulare Kräfte vorfixiert werden. Die Klemmung kann aber auch rein mechanisch erfolgen.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische Querschnittsdarstellung einer erfindungsgemäßen Vorrichtung in einer ersten Ausführungsform,
- Figur 1b: eine schematische Querschnittsdarstellung der erfindungsgemäßen Vorrichtung in einer zweiten Ausführungsform,
- Figur 1c: eine schematische Querschnittsdarstellung der erfindungsgemäßen Vorrichtung in einer dritten Ausführungsform,
- Figur 2a: eine schematische Darstellung eines erfindungsgemäßen Verfahrens in einem ersten Kalibrierungsschritt mit einem ersten Kalibriersubstrat,
- Figur 2b: eine schematische Darstellung des erfindungsgemäßen Verfahrens in einem zweiten Kalibrierungsschritt mit dem ersten Kalibriersubstrat,
- Figur 2c: eine schematische Darstellung des erfindungsgemäßen Verfahrens in einem dritten Kalibrierungsschritt mit dem ersten Kalibriersubstrat,
- Figur 2d: eine schematische Darstellung des erfindungsgemäßen Verfahrens in einem vierten Kalibrierungsschritt mit dem ersten Kalibriersubstrat,
- Figur 2e: eine schematische Darstellung des erfindungsgemäßen Verfahrens in einem fünften Kalibrierungsschritt mit dem ersten Kalibriersubstrat,
- Figur 2f: eine schematische Darstellung des erfindungsgemäßen Verfahrens in einem sechsten Kalibrierungsschritt mit dem ersten Kalibriersubstrat,
- Figur 3a: eine schematische Darstellung des erfindungsgemäßen Verfahrens in einem ersten Kalibrierungsschritt mit einem zweiten Kalibriersubstrat,
- Figur 3b: eine schematische Darstellung des erfindungsgemäßen Verfahrens in einem zweiten Kalibrierungsschritt mit dem zweiten Kalibriersubstrat,
- Figur 3c: eine schematische Darstellung des erfindungsgemäßen Verfahrens in einem dritten Kalibrierungsschritt mit dem zweiten Kalibriersubstrat,
- Figur 4a: eine schematische Darstellung des erfindungsgemäßen Verfahrens in einem ersten Verfahrensschritt zur Fixierung eines ersten Substrats an einer ersten Aufnahme,
- Figur 4b: eine schematische Darstellung des erfindungsgemäßen Verfahrens in einem zweiten Verfahrensschritt zur Erfassung einer Position des ersten Substrats,
- Figur 4c: eine schematische Darstellung des erfindungsgemäßen Verfahrens in einem dritten Verfahrensschritt zur Erfassung einer Position des ersten Substrats,
- Figur 4d: eine schematische Darstellung des erfindungsgemäßen Verfahrens in einem vierten Verfahrensschritt zur Erfassung einer Position eines zweiten Substrats,
- Figur 4e: eine schematische Darstellung des erfindungsgemäßen Verfahrens in einem fünften Verfahrensschritt zur Erfassung einer Position des zweiten Substrats,
- Figur 4f: eine schematische Darstellung des erfindungsgemäßen Verfahrens in einem sechsten Verfahrensschritt zum Ausrichten der Substrate,
- Figur 4g: eine schematische Darstellung des erfindungsgemäßen Verfahrens in einem siebten Verfahrensschritt zum Kontaktieren der Substrate,
- Figur 5a: eine schematische Darstellung eines Kalibrierzustands zweier Optiken, deren Schnittpunkt nicht zentrisch zu einer Markierung liegt,
- Figur 5b: eine schematische Darstellung eines Kalibrierzustands zweier Optiken, deren Schnittpunkt zentrisch zu einer Markierung liegt,
- Figur 6a: eine schematische Darstellung eines dritten erfindungsgemäßen Kalibrationsverfahrens in einem ersten Teilkalibrierschritt,
- Figur 6b: eine schematische Darstellung eines dritten erfindungsgemäßen Kalibrationsverfahrens in einem zweiten Teilkalibrierschritt,
- Figur 6c: eine schematische Darstellung eines dritten erfindungsgemäßen Kalibrationsverfahrens in einem dritten Teilkalibrierschritt,
- Figur 7: eine schematische, perspektivische Außendarstellung einer Ausführungsform der erfindungsgemäßen Vorrichtung und
- Figur 8: eine schematische Darstellung eines Clustersystems mit der erfindungsgemäßen Vorrichtung.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

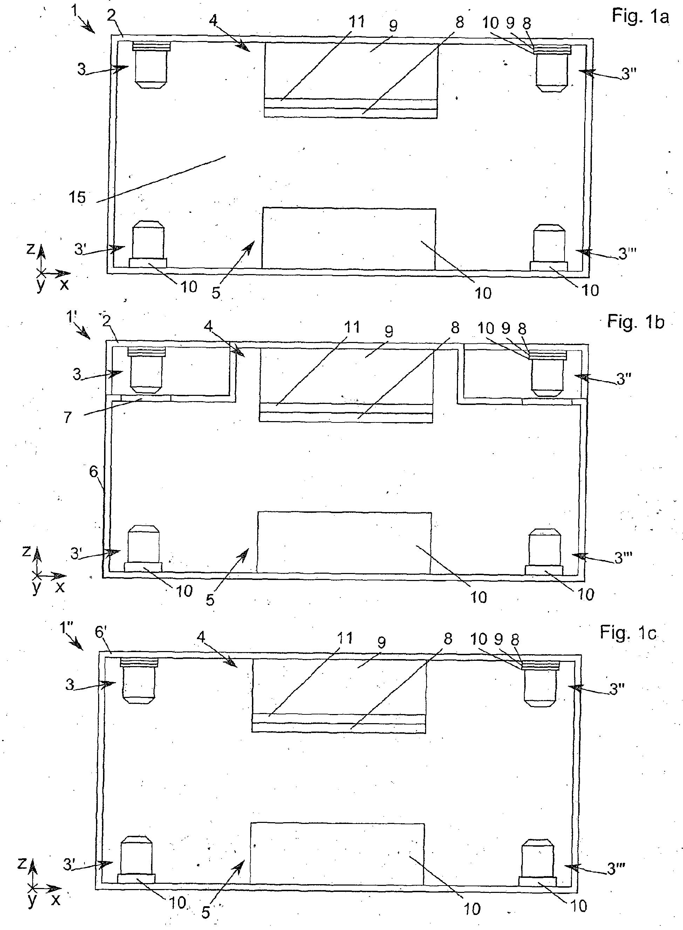

Die Figuren 1a-1c zeigen schematische Querschnitte von drei Ausführungsbeispielen erfindungsgemäßer Ausrichtungsanlagen 1, 1', 1", bestehend aus:
- einer erste Erfassungseinheit 3 in Form einer oder mit einer linken oberen Optik,
- einer zweiten Erfassungseinheit 3' in Form einer oder mit einer linken unteren Optik, sowie
- einer weiteren ersten Erfassungseinheit 3" in Form einer oder mit einer rechten oberen Optik und
- einer weiteren zweiten Erfassungseinheit 3''' in Form einer oder mit einer rechten unteren Optik,
- einer ersten Aufnahme 4 in Form einer oder mit einer oberen Aufnahme, sowie
- einer zweiten Aufnahme 5 in Form einer oder mit einer unteren Aufnahme 5.

Die ersten Erfassungseinheiten 3, 3", sind durch eine X-Translationseinheit 8, eine Y-Translationseinheit 9 und eine Z-Translationseinheit 10 in der Lage, sich in alle drei Raumrichtungen X, Y und Z zu bewegen. In besonderen Ausführungsformen wäre es auch noch denkbar, dass Rotationseinheiten eingebaut werden, welche eine Rotation der optischen Achse um drei zueinander orthogonale Achsen erlaubt. In einer besonderen Ausführungsform würde die eigentliche Optik dann beispielsweise auf einem Goniometer montiert werden. Um die Darstellung zu erleichtern, sind diese Rotationseinheiten nicht in den Zeichnungen dargestellt.

Die beiden zweiten, insbesondere unten angeordneten Erfassungseinheiten 3', 3''' weisen ausschließlich eine Z-Translationseinheit auf, so dass diese ausschließlich entlang der Z-Richtung bewegt werden können. Die erste Aufnahme 4 besitzt mindestens eine Y Translationseinheit 9, eine phi-Rotationseinheit 11, sowie eine X-Translationseinheit 8. Die zusätzliche Verwendung von Rotationseinheiten und/oder einer Z Translationseinheit sind ebenfalls denkbar.

Die X-Translationseinheit 8 besitzt einen vergleichsweise großen maximalen Verfahrweg, der insbesondere doppelt, vorzugsweise viermal, so groß ist wie der maximale Verfahrweg in Y-Richtung. Der Verfahrweg liegt insbesondere zwischen -0.1 mm und 0.1mm, mit Vorzug zwischen -1 mm und 1 mm, mit größerem Vorzug zwischen -5 mm und 5 mm, mit größtem Vorzug zwischen -50 mm und 50 mm, mit allergrößtem Vorzug zwischen - 150 mm und 150 mm.

Die Y-Translationseinheit 9 kann für das erfindungsgemäße Verfahren einen viel kleineren, dafür aber auf höher auflösbaren, Verfahrweg besitzen. Die Verfahrwege sind kleiner als 50 mm, mit Vorzug kleiner als 10 mm, mit größerem Vorzug kleiner als 5 mm, mit größtem Vorzug kleiner als 1 mm.

Die Auflösung des Positioniervermögens aller verwendeten Translationseinheiten ist insbesondere besser als 100µm, mit Vorzug besser als 10µm, mit größerem Vorzug besser als 1µm, mit größtem Vorzug besser als 100nm, am bevorzugtesten besser als 10nm.

Die phi-Rotationseinheit 11 erlaubt eine Drehung eines geladenen Kalibrierungssubstrats 13, 13' bzw. eines Substrats 14, 14' um deren Oberflächennormale. Die Rotationsmöglichkeit dient vor allem dem Ausgleich eines um einige Winkelgrade falsch vorjustierten Kalibrierungssubstrats 13, 13' bzw. Substrats 14, 14'. Die Auflösung des Positioniervermögens aller verwendeter Rotationseinheiten ist insbesondere besser als 1°, mit Vorzug besser als 0.1°, mit größerem Vorzug besser als 0.01°, mit größtem Vorzug besser als 0.001°, am bevorzugtesten besser als 0.0001°. Der Drehwinkel, den die phi-Rotationseinheit 11 ansteuern können muss, ist vergleichsweise gering, da die phi-Rotationseinheit 11 nur für sehr geringe Orientierungskorrekturen eines mit Vorzug bereits ideal geladenen Substrats, dient. Der Drehwinkel der phi-Rotationseinheit 11 ist daher insbesondere kleiner als 10°, mit Vorzug kleiner als 5°, mit größerem Vorzug kleiner als 1°.

Die in den Zeichnungen, als optimal angesehene, Reihenfolge der Y Translationseinheit 9, der phi Rotationseinheiten 11, sowie der X Translationseinheit 8 kann, falls nötig beliebig verändert werden. Eine weitere besonders bevorzugte Ausführungsform wäre die Fixierung der phi Rotationseinheit 11 auf den X- bzw. Y-Translationseinheiten 8,9 bzw. die Fixierung der X- bzw. Y-Translationseinheiten 8,9 auf der phi Rotationseinheit 11.

Figur 1a zeigt eine erfindungsgemäße erste Ausrichtungsanlage 1, bei der sich sämtliche Erfassungseinheiten 3, 3', 3" und 3'" sowie alle Aufnahmen 4, 5 unter Atmosphäre 15 befinden. Die genannten Bauteile sind höchstens über einen, im Allgemeinen zur Atmosphäre hin offenen, im Speziellen geschlossenen, aber nicht vakuumdichten, Rahmen 2 miteinander verbunden.

Figur 1b zeigt eine erfindungsgemäße zweite und bevorzugte Ausrichtungsanlage 1',bei der sich die erste Aufnahme 4, die zweite Aufnahme 5 sowie die zweiten Erfassungseinheiten 3', 3''' in einer Vakuumkammer 6 (oder Gehäuse) befinden, während die ersten Erfassungseinheiten 3, 3"außerhalb der Vakuumkammer 6 an einem Stützrahmen 2 montiert sind. Die Fenster 7 erlauben die Erfassung im Inneren der Vakuumkammer 6 über die Optiken der ersten Erfassungseinheiten 3, 3".

Figur 1c zeigt eine dritte erfindungsgemäße Ausrichtungsanlage 1", bei der sich alle erfindungsrelevanten/anspruchsgemäßen Bauteile innerhalb der Vakuumkammer 6' befinden.

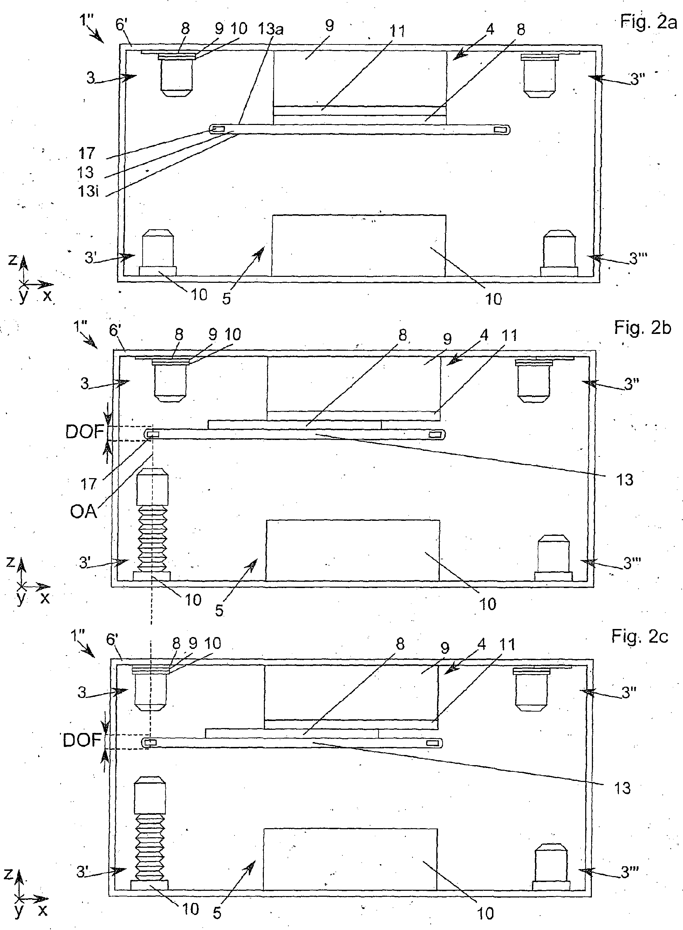

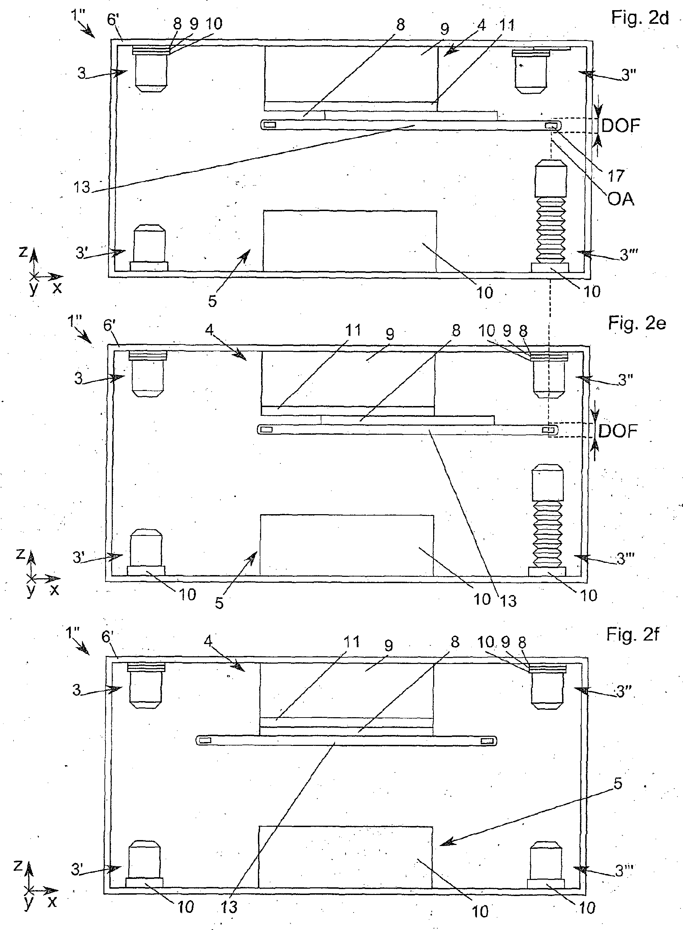

Die Figur 2a zeigt einen ersten erfindungsgemäßen Kalibrierungsschritt für die Kalibrierung der Schnittpunkte der optischen Achsen aller vier Erfassungsgeräte bzw. Optiken der ersten und zweiten Erfassungseinheiten 3, 3', 3" und 3''', der mit dem Fixieren eines ersten Kalibrierungssubstrats 13 an der ersten Aufnahme 4 beginnt. Der Probenhalter zur Fixierung des Kalibrierungssubstrats 13 wurde der Übersichtlichkeit halber nicht eingezeichnet.

Das Kalibrierungssubstrat 13 besitzt zwei Markierungen 17, insbesondere an jeweils gegenüberliegenden Seiten des äußeren Randbereichs der seitlichen Umfangskontur des Kalibrierungssubstrats 13. Das Material des Kalibrierungssubstrats 13 ist für die elektromagnetische Strahlung, die von den Erfassungsgeräten 3, 3', 3" und 3''' verwendet wird, transparent. Denkbar sind vor allem die Verwendung von sichtbarem Licht, von Infrarotstrahlung, von UV Strahlung oder jeder anderen denkbaren elektromagnetischen Strahlung, die zur Detektion von Ausrichtungsmarken herangezogen werden kann. Mit Vorzug handelt es sich allerdings um sichtbares Licht. Die Markierungen 17 befinden sich entweder an einer der beiden Oberflächen 13i, 13a des Kalibrierungssubtrats 13 oder in dessen Mitte (bezogen auf die Axialrichtung des Kalibrierungssubstrats 13).

In einem zweiten erfindungsgemäßen Kalibrierungsschritt gemäß Figur 2b verfährt die erste Aufnahme 4 das Kalibrierungssubstrat 13 durch ihre X-Translationseinheit 8 solange in die negative X-Richtung (also in der Figur 2b nach links), bis sich die linke Markierung 17 im Sichtbereich der unteren linken Optik befindet. Soweit sich die Markierung 17 im Allgemeinen nicht im Tiefenschärfebereich (engl.: depth of focus, DOF) der linken untere Optik befindet, wird die untere Optik 3' durch eine Z-Translationseinheit 10 entsprechend verfahren.

Ist die linke Markierung 17 im Sichtbereich und Tiefenschärfebereich der linken unteren Optik, kann durch die X- Translationseinheit 8 und/oder die Y-Translationseinheit 9 und/oder die phi-Rotationseinheit 11 der ersten Aufnahme 4 die exakte Positionierung der linken Markierung 17 zur optischen Achse OA der entsprechenden zweiten Erfassungseinheit 3', hier der linken unteren Optik, erfolgen.

Da sich die linke untere Optik erfindungsgemäß nicht in X- und/oder Y-Richtung bewegen kann, wird die Aufgabe der Markierungsausrichtung der Markierung 17 in Bezug auf die optische Achse OA der linken unteren Optik 3' von den Translationseinheiten und den Rotationseinheiten der ersten Aufnahme 4 durchgeführt. Die Bewegungen der Translationseinheiten und Rotationseinheiten sind erfassbar und die Erfassungsdaten werden an die zentrale Steuerungseinheit zur Weiterverarbeitung und Steuerung übertragen.

In einem in Figur 2c gezeigten dritten erfindungsgemäßen Kalibrierungsschritt mit dem ersten Kalibrierungssubstrat 13 wird mit der links angeordneten ersten Erfassungseinheit 3, hier der oberen linken Optik die linke Markierung 17 des Kalibrierungssubstrats 13 erfasst. Im Gegensatz zur unteren linken Optik besitzt die erste Erfassungseinheit 3 mindestens drei Translationsfreiheitsgrade.

Die obere linke Optik 3 verwendet daher ihre X-Translationseinheit 8, ihre Y-Translationseinheit 9 und ihre Z-Translationseinheit 10 zur Bewegung der Optik 3, um die linke Markierung 17 innerhalb des Sichtbereichs und Tiefenschärfebereichs zu erfassen. Soweit sich die linke obere Optik 3 in sehr geringer Höhe zum Kalibrierungssubstrat 13 befindet, ist keine oder nur eine geringe Änderung der Z-Position erforderlich.

Nachdem die optischen Achsen OA der linken unteren Optik und der linken oberen Optik auf die linke Markierung 17 ausgerichtet worden sind, können die entsprechenden Encoderpositionen aller Translations- und Rotationseinheiten der ersten Aufnahme 4, alle Encoderpositionen der Translationseinheiten der ersten Erfassungseinheit 3 und die Encoderpositionen der Z-Translationseinheit der zweiten Erfassungseinheit, 3' als Erfassungsdaten gespeichert werden. Die gespeicherten Encoderpositionen der oberen linken Optik 3, sowie die Encoderposition der z-Translationseinheit der unteren linken Optik 3' werden vorzugsweise als Nullpunkt gesetzt. Die Erfassungsdaten werden von der Steuerungseinrichtung verarbeitet.

In den Figuren 2d bis 2e erfolgt der oben beschriebene Kalibrierungsvorgang bezüglich der rechten Markierung 17 des ersten Kalibrierungssubstrats entsprechend. Nach der Kalibrierung der vier Erfassungseinheiten 3, 3', 3" und 3"' und der bzw. zu der oberen Aufnahme 4 wird das Kalibrierungssubstrat 17 in seine Ausgangsposition gemäß Figur 2f gefahren und kann wieder aus der erfindungsgemäßen Ausrichtungsanlage 1" entnommen werden.

Die Figur 2f zeigt den Endzustand nach der ersten Kalibrierung der erfindungsgemäßen Ausrichtungseinheit 1".

In einer vorteilhaften Ausführungsform wird das Kalibrierungssubstrat 13 mit genau einer Markierung 17 pro Seite gegen ein Kalibrierungssubstrat 13' ersetzt, das in den folgenden Abschnitten näher erklärt wird. Dieses Kalibrierungssubstrat 13' besitzt pro Seite nicht nur eine Markierung 17, sondern ein ganzes Markierungsfeld 18 mit mehreren Markierungen 17', also eine Markierungsmatrix. Diese besteht aus mehreren, in x- und y-Richtung an vorgegebenen und bekannten X- und Y-Positionen angeordneten Markierungen 17'. Die Markierungen 17' des zweiten Kalibrierungssubstrats 13' können insbesondere identisch oder unterschiedlich zu den Markierungen 17 des ersten Kalibrierungssubstrats 13 sein.

Es ist wichtig zu erwähnen, dass der bereits erwähnte erste Kalibrierschritt gemäß den Figuren 2a-2c auch mit einem Kalibrierungssubstrat 13' hätte ausgeführt werden können. Dadurch erspart man sich die teure Herstellung eines Kalibriersubstrats 13.

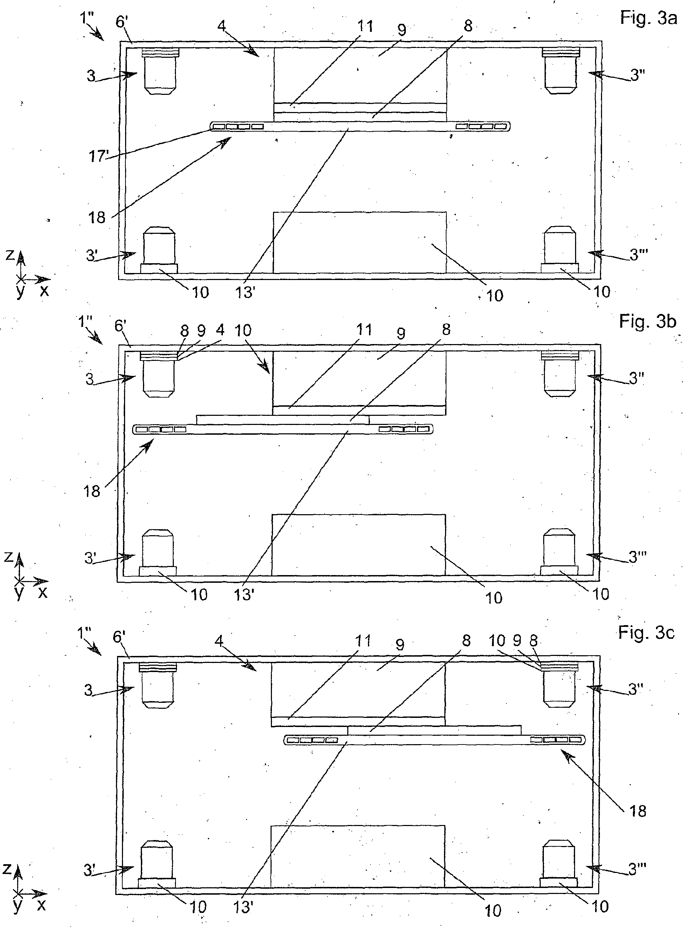

Die Figuren 3a-3c zeigen die Schritte eines erfindungsgemäßen Prozesses zur Kalibrierung der beiden ersten Erfassungseinheiten 3, 3" zueinander, mithin der oberen linken Optik und der oberen rechten Optik.

In einem ersten erfindungsgemäßen Kalibrierungsschritt gemäß Figur 3a wird das Kalibrierungssubstrat 13' geladen. Die Markierungen 17 des Markierungsfeldes 18 wurden durch einen hochauflösenden Schreibprozess, beispielsweise einem Elektronenschreibverfahren, in das Kalibrierungssubstrat 13' eingearbeitet. Die Markierungen 17' befinden sich wiederum entweder auf den Oberflächen des Kalibrierungssubstrats 13' oder in deren Mitte (bezogen auf die Normalenrichtung des Kalibrierungssubstrats 13'). Die Markierungen 17' des Markierungsfeldes 18 werden mit Vorzug durch photolithographische, elektronenlithographische oder ionenlithographische Prozesse hergestellt.

Der Vorzug des Markierungsfeldes 18 besteht in der sehr präzisen und exakten Orientierung bzw. Positionierung der unterschiedlichen Markierungen 17' zueinander. Die Abweichungen der Markierungen 17' von ihrer idealen X- und/oder Y-Position sind kleiner als 100µm, mit Vorzug kleiner als 10µm, mit größerem Vorzug kleiner als 1µm, mit größtem Vorzug kleiner als 100nm, mit allergrößtem Vorzug kleiner als 10nm. Damit stellt das Markierungsfeld 18 eine ideale Positionskarte dar, in Bezug auf die man eine Kalibrierung eines Gerätes mit geringerer Positionsauflösung durchführen kann. Die einzelnen Markierungen 17' des Markierungsfeldes 18 sind insbesondere kleiner als 500 x 500 µm, mit Vorzug kleiner als 300 x 300 µm, mit größerem Vorzug kleiner als 100 x 100 µm, mit größtem Vorzug kleiner als 50 x 50 µm, mit allergrößtem Vorzug kleiner als 10 x 10 µm.

In einem in Figur 3b gezeigten zweiten erfindungsgemäßen Kalibrierungsschritt mit dem zweiten Kalibrierungssubstrat 13' wird dieses so weit in die negative X-Richtung bewegt, bis große Teile des Markierungsfeldes 18, mit Vorzug der geometrische Mittelpunkt des Markierungsfeldes 18, im Sichtbereich der linken oberen Optik 3 angeordnet sind.

Die linke obere Optik 3 wurde im vorhergehenden Kalibrierungsprozess mit dem ersten Kalibrierungssubstrat 13 bezüglich der Markierung 17 des ersten Kalibrierungssubstrats 13 geeicht. Die erste Erfassungseinheit 3 befindet sich somit in der Ausgangslage (vorzugsweise Nullpunkt) bezüglich ihrer X- und Y-Position. Die linke obere Optik besitzt im Gegensatz zur linken unteren Optik die Möglichkeit einer Bewegung in X- und Y-Richtung.

Um eine korrekte, schnelle, präzise und vor allem reproduzierbare Ansteuerung der X-Y-Positionenzu erreichen, werden mit der ersten Erfassungseinheit 3 (linke obere Optik) nacheinander alle Markierungen 17' des Markierungsfeldes 18 abgerastert, indem das Zentrum einer jeder Markierung 17' des Markierungsfeldes 18 mit der optischen Achse OA der linken oberen Optik erfasst wird. Einer jeden so erreichten X-Y-Position werden alle Positionsmerkmale der ersten Erfassungseinheit 3 zugeordnet, also mindestens die X-Position der X-Translationseinheit 8 und die Y-Position der Y-Translationseinheit 9, mit Vorzug auch die Z-Position der Z-Translationseinheit 10. Damit wird die Position der ersten Erfassungseinheit 3 auf die hochpräzisen, als ideal angenommenen Werte der Markierungen 17' des Markierungsfeldes 18 erfasst. Die so erhaltenen Werte der Positionen können als Positionskarte gespeichert und für die linke obere Optik darüber hinaus zur Interpolation verwendet werden.

In einem in Figur 3c gezeigten dritten erfindungsgemäßen Kalibrierungsschritt mit dem zweiten Kalibrierungssubstrat 13' erfolgt der gleiche Vorgang, für das Markierungsfeld 18 der rechten Seite des Kalibrierungssubstrats 13', und damit die Kalibrierung der ersten Erfassungseinheit 3" (rechte obere Optik).

Damit sind alle Kalibrierungsschritte für alle vier Optiken 3,3',3" und 3''' abgeschlossen.

Die Kalibrierung wird nicht für jeden Ausrichtungsvorgang benötigt, sondern nur in regelmäßigen Intervallen oder bei der Feststellung von Abweichungen beim Ausrichtungsvorgang. Die Feststellung kann insbesondere durch ein Metrology-Modul erfolgen.

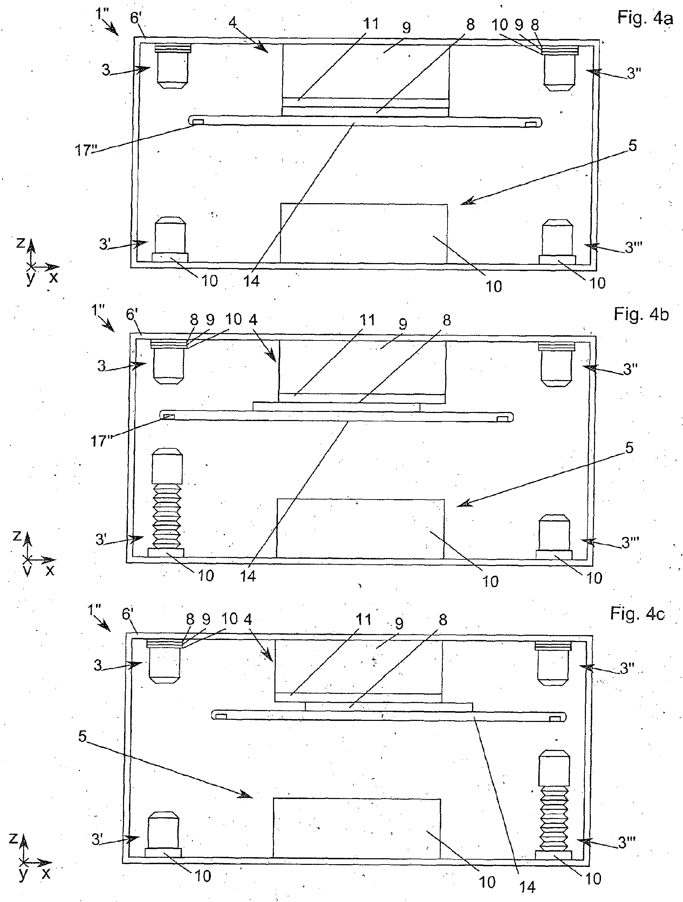

In einem ersten Schritt einer Ausführungsform des erfindungsgemäßen Ausrichtungsprozesses gemäß Figur 4a wird ein erstes Substrat 14 mit linken und rechten Ausrichtungsmarken 17" in Ausrichtungsanlage 1" geladen. Die ersten und zweiten Erfassungseinheiten 3, 3', 3" und 3''' befinden sich dabei mit Vorzug in Z-Richtung möglichst weit von dem ersten Substrat 14 entfernt, um ein Laden des ersten Substrats 14 zu vereinfachen.

In einem zweiten Schritt eines erfindungsgemäßen Ausrichtungsprozesses gemäß Figur 4b wird das erste Substrat 14 so weit nach links bewegt, dass die linke Markierung 17" im Sichtbereich der zweiten Erfassungseinheit 3' (linke untere Optik) verortet ist. Die linke untere Optik kann gleichzeitig oder unmittelbar anschließend in Z-Richtung auf die gespeicherte Nullposition fahren und sollte damit die Markierung 17" im Tiefenschärfebereich haben. Für den Fall, dass sich die Markierungen 17" nicht im Tiefenschärfebereich befinden, wird die z-Position der Erfassungseinheit 3' entsprechend um diesen Nullpunkt verändert, bis ein scharfes Bild der Markierung 17" entsteht. Etwaige Korrekturen der Z-Position sind durch ein Verfahren der linken unteren Optik 3' entlang der Z-Richtung vorzunehmen. Da die zweite Erfassungseinheit 3' sich nicht entlang der X- und/oder Y-Richtung bewegen kann, muss die linke Markierung 17" des Substrats 14 durch die X-Translationseinheit 8 und/oder die Y-Translationseinheit 9 der ersten (oberen) Aufnahme 4 mit der optischen Achse OA der linken unteren Optik 3' zur Deckung gebracht werden. Nach erfolgreicher Erfassung speichert das System die korrespondierenden Encoderpositionen der Translations- und Rotationseinheiten der ersten Aufnahme 4, insbesondere in der Steuerungseinrichtung.

Als nächstes erfolgt gemäß Figur 4c ein analoger Schritt für die Ermittlung der Encoderpositionen der Translations- und Rotationseinheiten der oberen Aufnahme 4 bezüglich der rechten Markierung 17 des ersten Substrats 14 und der weiteren zweiten Erfassungseinheit 3"' (rechte untere Optik).

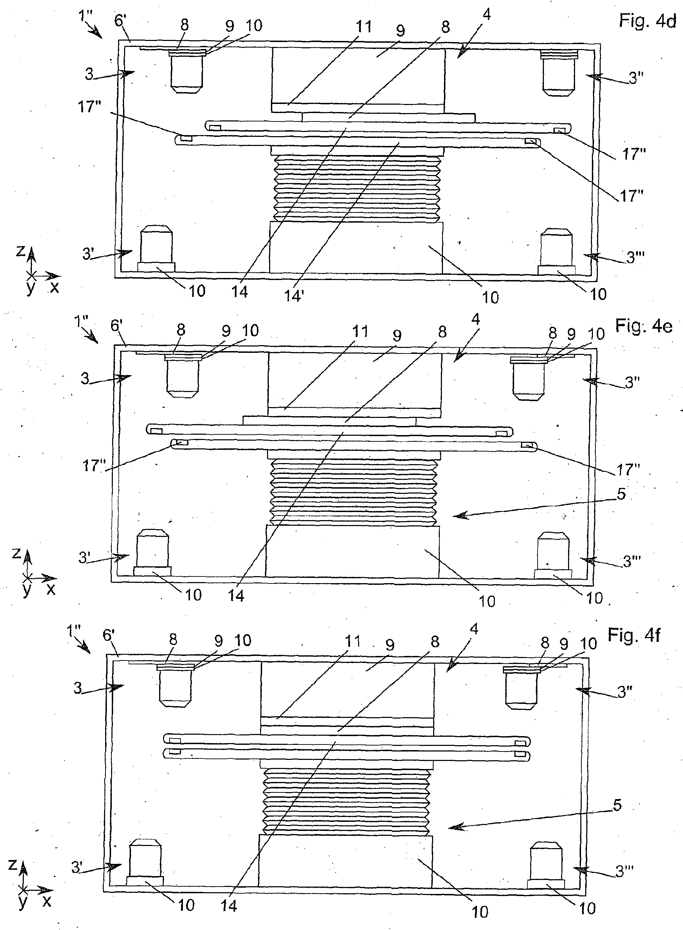

In einem vierten Schritt des erfindungsgemäßen Ausrichtungsprozesses gemäß Figur 4d wird ein zweites Substrat 14'auf der zweiten (unteren) Aufnahme 5 fixiert und in Z-Richtung an das erste Substrat 14 angenähert. Der Probenhalter wurde der Übersichtlichkeit halber nicht eingezeichnet.

Erfindungsgemäß besitzt die zweite Aufnahme 5 insbesondere nur eine Z-Translationseinheit 10, so dass das Substrat 14'weder in X- noch in Y-Richtung bewegt werden kann.

Auf Grund des vorhergehendes Schrittes befindet sich das erste Substrat 14 soweit auf der rechten Seite, dass die linke Markierung 17" des unteren Substrats 14' von der ersten Erfassungseinheit 3 (obere linke Optik) erfassbar ist. Diese wird in X- und/oder Y-Richtung bewegt, um die linke Markierung 17" des zweiten Substrats 14' mit seiner optischen Achse zur Deckung zu bringen bzw. um die X-Y-Position zu erfassen. Da die erste Erfassungseinheit 3 im Kalibrierungsschritt gemäß Figur 3b auf eine ideale Positionskarte geeicht/kalibriert wurde, ist die reale X-Y Position der ersten Erfassungseinheit 3 ermittelbar und auf die ideale X-Y-Position abbildbar. Die Encoderpositionen der X-Translationseinheit 8 und der Y-Translationseinheit 9 werden gespeichert und der linken Markierung 17" des zweiten Substrats 14' zugeordnet.

In einem in Figur 4e gezeigten vierten Schritt einer Ausführungsform eines erfindungsgemäßen Ausrichtungsprozesses erfolgt die Verschiebung der weiteren ersten Erfassungseinheit 3", um die rechte Markierung 17" des zweiten Substrats 14' zu erfassen bzw. um diese mit der optischen Achse der rechten oberen Optik zur Deckung zu bringen. Vorher wird das erste Substrat 14 nach links verschoben, um der oberen rechten Optik freie Sicht auf die rechte Markierung 17" des zweiten Substrats 14' zu geben und die Erfassung zu ermöglichen.

Alternativ kann die Erfassung auch aus schräger Richtung erfolgen, so dass keine Verschiebung des ersten Substrats 14 nötig ist.

Nach der Ermittlung aller notwendigen Parameter erfolgt in einem erfindungsgemäßen fünften Schritt gemäß Figur 4f eine Ausrichtung der beiden Substrate 14, 14', insbesondere ohne Zuhilfenahme optischer Geräte wie der Erfassungseinheiten 3, 3', 3", 3"'. Durch die X-Y Positionen der beiden ersten Erfassungseinheiten 3, 3" ist ein X-Abstand der Markierungen 17" des zweiten Substrats 14' zu den Verbindungslinien zwischen den linken Optiken und den rechten Optiken bzw. zu den optischen Achsen der Erfassungspaare der ersten und zweiten Erfassungseinheiten 3, 3', 3", 3'" bekannt. Durch die Encoderpositionen der ersten Aufnahme 4 sind die X-Y-Positionen der Markierungen 17" des oberen Substrats 14 zu den Verbindungslinien oder optischen Achsen bekannt. Da das zweite Substrat 14' in X- und Y-Richtung fixiert ist, erfolgt die Berechnung und danach die Ansteuerung der Position des oberen Substrats 14 so, dass sich die Markierungen 17" des ersten Substrats 14 exakt über den korrespondierenden Markierungen 17" des zweiten Substrats 14' befinden.

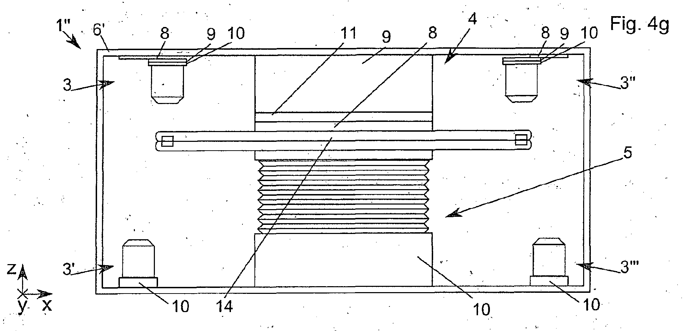

In einem siebten Schritt eines erfindungsgemäßen Ausrichtungsprozesses gemäß Figur 4g erfolgt schließlich die Kontaktierung beider Substrate 14, 14', vorzugsweise ausschließlich durch eine Bewegung der Z-Translationseinheit 10 der zweiten Aufnahme 5, um eine falsche Kontaktierung der bereits angefahrenen optimalen X-Y Position des oberen Substrats 14 zu vermeiden.

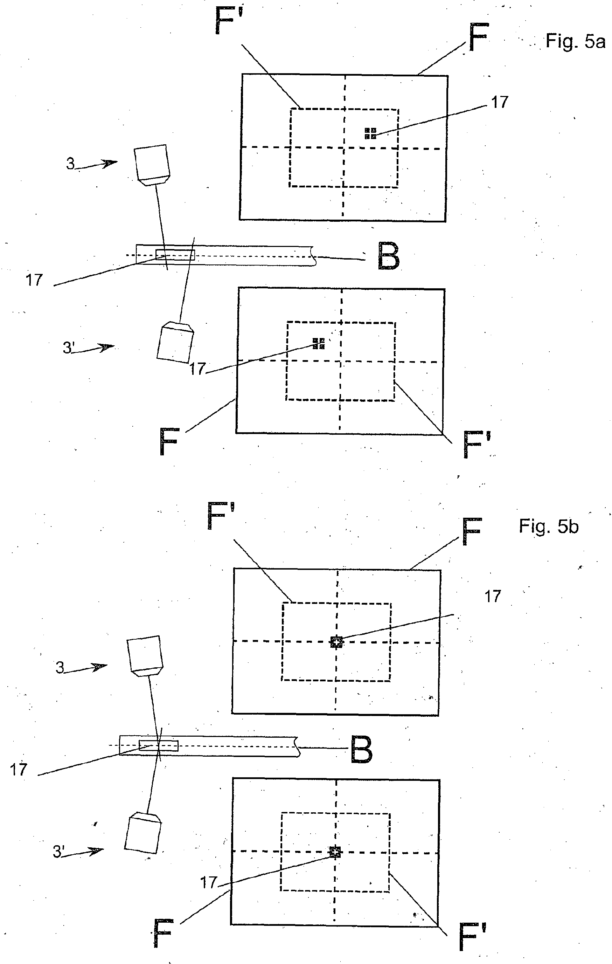

Die beiden Figuren 5a und 5b zeigen noch eine schematische Darstellung der beiden grundsätzlich möglichen Kalibrierungen der Optiken 3, 3' auf die Markierung 17.

Figur 5a zeigt den optimalen, da schnelleren und kosteneffizienteren Vorgang der Justierung zweier optischer Achsen. Die beiden optischen Achsen 3,3' besitzen keinen Schnittpunkt, oder der Schnittpunkt liegt zumindest nicht innerhalb der Markierung 17. Die optischen Achsen schneiden die spätere Bondebene B links bzw. rechts der Mitte der Markierung 17. Dementsprechend verschoben erscheint die Markierung 17 in den Optiken 3, 3', bzw. den entsprechend digitalisierten Sensordaten. Erfindungsgemäß wird die Distanz zwischen den Bildern der Ausrichtungsmarke 17 bestimmt, um einen Offset der optischen Achsen zur Markierung 17 zu bestimmen. Somit ist eine absolut genaue Kalibrierung der optischen Achsen auf einen Punkt nicht notwendig. Der Offset kann verwendet werden, um die exakten Positionen für die spätere Kalibrierung der beiden Substrate zu ermitteln.

In der Fig. 5b erkennt man die optimale, aber weniger wünschenswerte, da zeitintensivere und kostspieligere Kalibrierung, bei der der Schnittpunkt beider optischer Achsen der Optiken 3, 3' exakt in der Markierung 17 zu liegen kommt. Dementsprechend erkennt man in den Optiken 3, 3', bzw. den entsprechend digitalisierten Sensordaten, dass sich die Markierungen 17 genau im Zentrum des digitalisierten Bildes befinden.

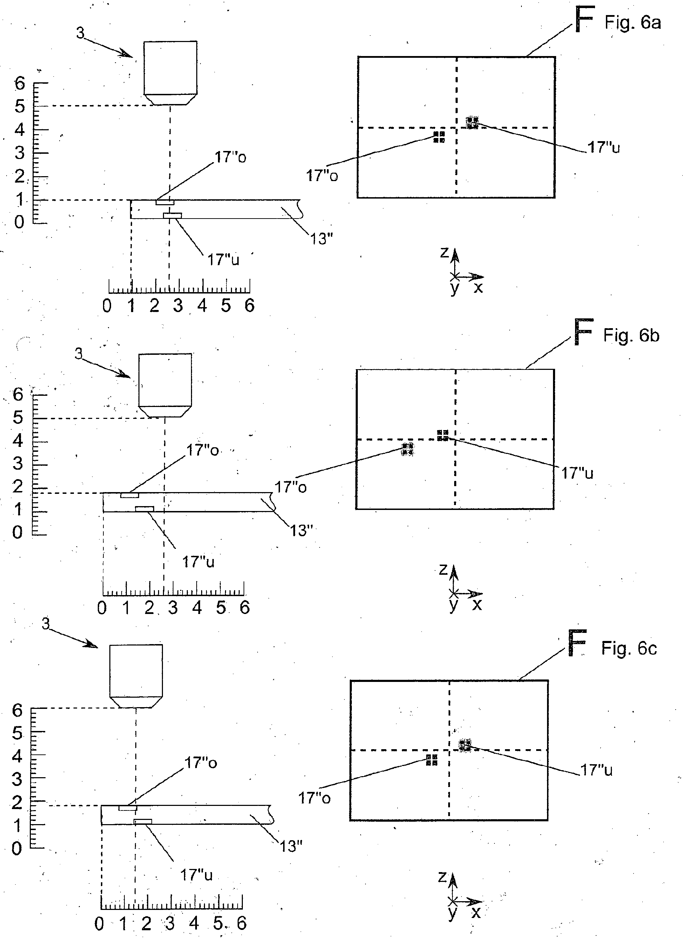

Die Figuren 6a-6c zeigen drei Teilkalibrierschritte für einen Zyklus eines erfindungsgemäßen dritten Kalibrierverfahrens für die Abweichung der z-Translationseinheit 10 entlang der x-y Richtung während der Bewegung entlang der z-Achse. Das entsprechende Verfahren wird anhand der linken Seite eines Kalibriersubstrats 13" veranschaulicht.

Das Kalibriersubstrat 13" mit einer oberen Markierung 17"o und einer unteren Markierung 17"u, befindet sich unter der linken, oberen Optik 3. Die linke, obere Optik 3 wird so positioniert, dass zumindest die obere Markierung 17o" fokussiert ist (sollte der Tiefenschärfebereich der linken, oberen Optik,3 groß genug bzw. das Kalibriersubstrats 13" dünn genug sein, kann auch die untere Markierung 17"u bereits fokussiert sein). In dieser Position besitzt die Optik eine vertikale Position 5 (linke Skala) und eine horizontale Position 2,6 (untere Skala). Das Kalibriersubstrat 13" befindet sich in der vertikalen Position 1 und der horizontalen Position 1.

Das Kalibriersubstrats 13" wird gemäß Figur 6b auf die vertikale Position 1,8 bewegt und erfährt dabei eine Verschiebung der horizontalen Position von 1 auf 0. In der Querschnittsdarstellung ist nur eine Verschiebung entlang der x-Achse und der z-Achse erkennbar. Entsprechen kann das Kalibriersubstrat 13" auch noch entlang der y-Achse verschoben werden. Durch diese Annäherung des Kalibriersubstrats 13" an die obere Optik 3 kommt die untere Markierung 17u" in den Fokus (während die obere Markierung 17"o aus dem Tiefenschärfebereich fährt und damit nicht mehr fokussiert ist).

Die während der Annäherung des Kalibriersubstrats 13" entstandene Verschiebung in x- und/oder y-Richtung wird von einer Software gespeichert. Das Kalibriersubstrat 13" verbleibt auf der vertikalen Position 1,8 und der horizontalen Position 0, während die linke, obere Optik 3 wiederum die obere Markierung 17"o fokussiert. Dabei stellt die obere Optik 3 auch ihre horizontale Position von ursprünglich 2,6 auf 1,4, um die Markierung 17"o wiederum im selben Abstand zur optischen Achse OA vorzufinden, wie im ersten Teilkalibrierschritt gemäß Figur 6a. Die eben beschriebenen Teilkalibrierschritte können nun beliebig oft wiederholt werden um eine entsprechend große Strecke entlang der z-Richtung abzufahren und die jeweilige Verschiebung der z-Translationseinheit 10 entlang der x- und/oder y-Richtung zu bestimmen und als funktionalen Zusammenhang abzuspeichern.

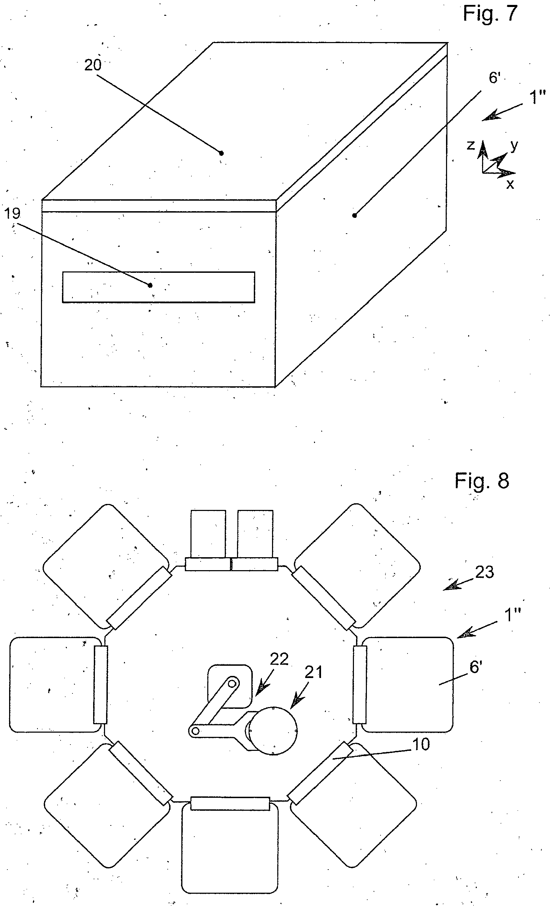

Figur 7 zeigt eine isometrische Darstellung einer erfindungsgemäßen Ausrichtungsanlage 1', bei der sich alle Elemente innerhalb der Vakuumkammer 6' befinden. Die Substrate 13, 13', 14, 14' werden dabei über ein Schleusentor 19 be- und entladen.
Figur 8 zeigt einen Cluster 23, mit Vorzug einen Vakuumcluster, mit größerem Vorzug einen Hochvakuumcluster 23, indem die erfindungsgemäße Ausführungsform 1" eines von mehreren Modulen ist. Die Substrate 13, 13', 14, 14 sowie der fertige Substratstapel 21 zweier zueinander ausgerichteter Substrate 14, 14' werden über einen Roboter 22 zwischen den unterschiedlichen Modulen transportiert, um verschiedene Bearbeitungsschritte auszuführen.

### Bezugszeichenliste

- 1,1',1": Ausrichtungsanlage
- 2: Stützrahmen
- 3, 3": Erste Erfassungseinheiten
- 3', 3"': Zweite Erfassungseinheiten
- 4: Erste Aufnahme
- 5: Zweite Aufnahme
- 6, 6', 6": Vakuumkammer
- 7: Fenster
- 8: X-Translationseinheiten
- 9: Y-Translationseinheiten
- 10: Z-Translationseinheiten
- 11: Phi-Rotationseinheiten
- 12: Ausrichtungskammer
- 13, 13', 13": Kalibrierungssubstrat
- 13i, 13a: Kalibriersubstratoberflächen
- 14: Erstes Substrat
- 14': Zweites Substrat
- 15: Atmosphärenbereich
- 16: Vakuumbereich
- 17, 17', 17"o, 17"u: Markierungen
- 18: Markierungsfeld
- 19: Schleusentor
- 20: Deckel
- 21: Substratstapel
- 22: Roboter
- 23: Vakuumcluster
- OA: Optische Achse
- DOF: Tiefenschärfebereich, engl.: depth of focus
- A: Abstand
- F: Sichtbereich (engl.: field of view)
- F': Bevorzugter Aufenthaltsbereich der Markierung

## Patentansprüche

1. Verfahren zum Ausrichten und Kontaktieren eines ersten Substrats (14) mit einem zweiten Substrat (14') mit folgenden Schritten, insbesondere folgendem Ablauf:
- Fixierung des ersten Substrats (14) auf einer ersten Aufnahme (4) und des zweiten Substrats (14') auf einer zweiten Aufnahme (5), die der ersten Aufnahme (4) gegenüberliegend angeordnet ist, wobei das erste und zweite Substrat (14, 14') zwischen der ersten und zweiten Aufnahme (4, 5) mit einem Abstand A zwischen einer ersten Kontaktfläche des ersten Substrats (14) und einer zweiten Kontaktfläche des zweiten Substrats (14') angeordnet werden,
- Erfassung von ersten Markierungen (17") des ersten Substrats (14) und zweiten Markierungen (17") des zweiten Substrats (14') durch mindestens vier Erfassungseinheiten (3, 3', 3", 3'''), wovon:
a) mindestens zwei erste Erfassungseinheiten (3, 3") zumindest in X-Richtung und in Y-Richtung verfahrbar sind und
b) mindestens zwei zweite Erfassungseinheiten (3', 3''') beim Erfassen in einer quer zur X- und Y-Richtung verlaufenden Z-Richtung verfahren werden,
- Ausrichtung des ersten Substrats (14) gegenüber dem zweiten Substrat (14') in einer X-Richtung und einer dazu quer verlaufenden Y-Richtung mittels Bewegung der Substrate (14, 14') durch die Aufnahmen (4, 5) und
- Kontaktierung der Kontaktflächen der ausgerichteten Substrate (14, 14') in Z-Richtung,
- wobei das an der zweiten Aufnahme (5) fixierte zweite Substrat (14') ausschließlich in der Z-Richtung verfahrbar ist,
wobei das erste Substrat (14) derart in der X- und/oder Y-Richtung verfahren wird, dass eine linke zweite Erfassungseinheit (3') eine linke Markierung (17") auf dem ersten Substrat (14) erfasst,
wobei das erste Substrat (14) derart in der X- und/oder Y-Richtung verfahren wird, dass eine rechte zweite Erfassungseinheit (3'") eine rechte Markierung (17") auf dem ersten Substrat (14) erfasst,
wobei eine linke erste Erfassungseinheit (3) derart in der X- und/oder Y-Richtung verfahren wird, dass eine linke Markierung (17") auf dem zweiten Substrat (14') durch die linke erste Erfassungseinheit (3) erfasst wird, wobei das zweite Substrat (14') ausschließlich in der Z-Richtung beweglich ist,
wobei eine rechte erste Erfassungseinheit (3") derart in der X- und/oder Y-Richtung verfahren wird, dass eine rechte Markierung (17") auf dem zweiten Substrat (14') durch die rechte erste Erfassungseinheit (3") erfasst wird, **dadurch gekennzeichnet, dass** die mindestens zwei ersten Erfassungseinheiten (3, 3") unabhängig vom ersten Substrat (14) beweglich sind und dass die mindestens zwei zweiten Erfassungseinheiten (3', 3"') beim Erfassen ausschließlich in der Z-Richtung verfahren werden.

2. Verfahren nach Anspruch 1, bei dem die Ausrichtung im Vakuum bei weniger als 1 bar, mit Vorzug weniger als 10⁻³ mbar, mit größerem Vorzug weniger als 10⁻⁵ mbar, mit größtem Vorzug weniger als 10⁻⁷ mbar, am bevorzugtesten weniger als 10⁻⁹ mbar erfolgt.

3. Verfahren nach einem der vorhergehenden Ansprüche, bei dem die Erfassungsmittel vor dem Ausrichten kalibriert werden, insbesondere mit mindestens einem ersten Kalibriersubstrat (13), bevorzugt zusätzlich mit einem zweiten, unterschiedlich zum ersten Kalibriersubstrat (13) ausgebildeten Kalibriersubstrat (13').

4. Verfahren nach Anspruch 3, bei dem das erste Kalibriersubstrat (13) zur Kalibierung von optischen Achsen jeweils gegenüberliegend anordenbarer Erfassungseinheiten und/oder zur Kalibrierung der Tiefenschärfe der Erfassungseinheiten in Bezug auf das erste Kalibriersubstrat (13) verwendet wird.

5. Verfahren nach Anspruch 3 oder 4, bei dem das zweite Kalibriersubstrat (13') zur Kalibierung der ersten Erfassungseinheiten (3, 3") gegenüber der Bewegung des ersten Substrats (14) auf der ersten Aufnahme (4) in X-Richtung und Y-Richtung verwendet wird.

6. Verfahren nach einem der vorhergehenden Ansprüche, bei dem die Steuerung und Erfassung der Bewegungen der Substrate (14, 14') mittels der Aufnahmen (4, 5) und die Steuerung und Erfassung der Bewegung der Erfassungseinheiten (3, 3', 3", 3''') und zur Steuerung und Erfassung der Bewegung der Kontaktierungsmittel durch eine Steuerungseinrichtung gesteuert werden.

7. Vorrichtung zum Ausrichten und Kontaktieren eines ersten Substrats (14) mit einem zweiten Substrat (14') mit:
- einer ersten Aufnahme (4) zur Fixierung und Bewegung des ersten Substrats (14) und einer der ersten Aufnahme (4) gegenüberliegend angeordneten zweiten Aufnahme (5) zur Fixierung und Bewegung des zweiten Substrats (14'), wobei das erste und zweite Substrat (14, 14') zwischen der ersten und zweiten Aufnahme (4, 5) mit einem Abstand A zwischen einer ersten Kontaktfläche des ersten Substrats (14) und einer zweiten Kontaktfläche des zweiten Substrats (14') in einer X-Richtung, einer dazu quer verlaufenden Y-Richtung und einer quer zur X- und Y-Richtung verlaufenden Z-Richtung ausrichtbar sind,
- mindestens vier Erfassungseinheiten (3, 3', 3", 3'"), wovon:
a) mindestens zwei erste Erfassungseinheiten (3, 3") zumindest in X-Richtung und in Y-Richtung verfahrbar sind und
b) mindestens zwei zweite Erfassungseinheiten (3', 3"') in Z-Richtung verfahrbar sind,
- Kontaktierungsmitteln zur Kontaktierung des gegenüber dem zweiten Substrat (14') ausgerichteten ersten Substrats (14) mit dem zweiten Substrat (14') in Z-Richtung und
- einer Steuerungseinrichtung zur Steuerung und Erfassung der Bewegungen der Substrate (14, 14') mittels der Aufnahmen (4, 5) und zur Steuerung und Erfassung der Bewegung der Erfassungseinheiten (3, 3', 3", 3''') und zur Steuerung und Erfassung der Bewegung der Kontaktierungsmittel,
- wobei das an der zweiten Aufnahme (5) fixierte zweite Substrat (14') ausschließlich in der Z-Richtung verfahrbar ist,
wobei das erste Substrat (14) derart in der X- und/oder Y-Richtung verfahrbar ist, dass eine linke zweite Erfassungseinheit (3') eine linke Markierung (17") auf dem ersten Substrat (14) erfasst,
wobei das erste Substrat (14) derart in der X- und/oder Y-Richtung verfahrbar ist, dass eine rechte zweite Erfassungseinheit (3"') eine rechte Markierung (17") auf dem ersten Substrat (14) erfasst,
wobei eine linke erste Erfassungseinheit (3) derart in der X- und/oder Y-Richtung verfahrbar ist, dass eine linke Markierung (17") auf dem zweiten Substrat (14') durch die linke erste Erfassungseinheit (3) erfasst wird, wobei das zweite Substrat (14') ausschließlich in der Z-Richtung beweglich ist,
wobei eine rechte erste Erfassungseinheit (3") derart in der X-und/oder Y-Richtung verfahrbar ist, dass eine rechte Markierung (17") auf dem zweiten Substrat (14') durch die rechte erste Erfassungseinheit (3") erfasst wird,
**dadurch gekennzeichnet, dass** die mindestens zwei ersten Erfassungseinheiten (3, 3") unabhängig vom ersten Substrat (14) beweglich sind und dass die mindestens zwei zweiten Erfassungseinheiten (3', 3"') beim Erfassen ausschließlich in der Z-Richtung verfahren werden.

8. Vorrichtung nach Anspruch 7, wobei die erste Aufnahme (4) eine, insbesondere ausschließlich linear verfahrbare, X-Translationseinheit, eine, insbesondere ausschließlich linear verfahrbare, Y-Translationseinheit und eine, insbesondere ausschließlich linear verfahrbare, Z-Translationseinheit aufweist.

9. Vorrichtung nach Anspruch 7 oder 8, wobei die zweite Aufnahme (5) eine, insbesondere ausschließlich linear verfahrbare, Z-Translationseinheit aufweist.

10. Vorrichtung nach einem der Ansprüche 7 bis 9, wobei die ersten Erfassungseinheiten (3, 3") seitlich gegenüberliegend von der ersten Aufnahme (4) und/oder die zweiten Erfassungseinheiten (3', 3''') seitlich gegenüberliegend von der zweiten Aufnahme (5) angeordnet sind.

11. Vorrichtung nach einem der Ansprüche 7 bis 10, wobei die ersten Erfassungseinheiten (3, 3") jeweils eine, insbesondere ausschließlich linear verfahrbare, X-Translationseinheit, eine, insbesondere ausschließlich linear verfahrbare, Y-Translationseinheit und eine, insbesondere ausschließlich linear verfahrbare, Z-Translationseinheit aufweisen.

12. Vorrichtung nach einem der Ansprüche 7 bis 11, wobei die zweiten Erfassungseinheiten (3', 3"') jeweils eine, insbesondere ausschließlich linear verfahrbare, Z-Translationseinheit aufweisen.

13. Vorrichtung nach einem der Ansprüche 7 bis 12, wobei jeweils eine erste Erfassungseinheit (3, 3") und jeweils eine zweite Erfassungseinheit (3', 3''') gegenüberliegend zueinander anordenbar sind.

## Claims

1. Method for aligning and bringing a first substrate (14) into contact with a second substrate (14') with the following steps in particular, the following course of action:
- Fixing the first substrate (14) to a first holder (4) and the second substrate (14') to a second holder (5), which is arranged opposite to the first holder (4), whereby the first and second substrates (14, 14') are arranged between the first and second holders (4, 5) at a distance A between a first contact surface of the first substrate (14) and a second contact surface of the second substrate (14'),
- Detecting first markings (17") of the first substrate (14) and second markings (17") of the second substrate (14') by at least four detection units (3, 3', 3", 3"'), whereupon:
a) At least two first detection units (3, 3") can be moved at least in X-direction and in Y-direction, and
b) At least two second detection units (3', 3"') are moved during the detection in a Z-direction, wherein the Z-direction is arranged crosswise to the X- and Y-direction
- Aligning the first substrate (14) relative to the second substrate (14') in X-direction and Y-direction running crosswise thereto by means of movement of the substrates (14, 14') through the holders (4, 5), and
- Bringing into contact the contact surfaces of the aligned substrates (14, 14') in Z-direction.
wherein the second substrate (14') that is fixed to the second holder (5) can be moved exclusively in the Z-direction.
wherein the first substrate (14) is moved in the X- and/or Y-direction such that a left second detection unit (3') detects a left marking (17") on the first substrate (14),
wherein the first substrate (14) is moved in the X- and/or Y-direction such that a right second detection unit (3"') detects a right marking (17") on the first substrate (14),
wherein a left first detection unit (3) is moved in the X- and/or Y-direction such that a left marking (17") on the second substrate (14') is detected by the left first detection unit (3), wherein the second substrate (14') is moveable exclusively in the Z-direction,
wherein a right first detection unit (3") is moved in the X- and/or Y-direction such that a right marking (17") on the second substrate (14') is detected by the right first detection unit (3"),
**characterized in that** the at least two first detection units (3, 3") are moveable independently from the first substrate (14) and that the at least two second detection units (3', 3''') are moved during detection exclusively in the Z-direction.

2. Method according to Claim 1, in which the alignment in the vacuum is carried out at less than 1 bar, preferably less than 10⁻³ mbar, more preferably less than 10⁻⁵ mbar, most preferably less than 10⁻⁷ mbar, and in a most preferred manner less than 10⁻⁹ mbar.

3. Method according to one of the proceeding claims, in which the detecting means are calibrated before the alignment, in particular with at least one first calibrating substrate (13), preferably in addition with a second calibrating substrate (13') that is designed in a different manner to the first calibrating substrate (13).

4. Method according to Claim 3, in which the first calibrating substrate (13) is used for calibrating optical axes of detection units that can be arranged opposite to each other and/or for calibrating the depth of focus of the detection units relative to the first calibrating substrate (13).

5. Method according to Claim 3 or 4, in which the second calibrating substrate (13') is used for calibrating the first detection units (3, 3") relative to the movement of the first substrate (14) on the first holder (4) in the X-direction and in the Y-direction.

6. Method according to one of the proceeding claims, in which the control and detection of the movements of the substrates (14, 14') by means of the holders (4, 5) and the control and detection of the movement of the detection units (3, 3', 3", 3"') and for controlling and detection of the movement of the contacting means are controlled by a control system.

7. Device for aligning and bringing a first substrate (14) into contact with a second substrate (14') with:
A first holder (4) for fixing and moving the first substrate (14) and a second holder (5) arranged opposite to the first holder (4) for fixing and moving the second substrate (14'), whereby the first and second substrates (14, 14') can be aligned between the first and second holder (4, 5) at a distance A between a first contact surface of the first substrate (14) and a second contact surface of the second substrate (14') in an X-direction, a Y-direction running crosswise thereto, and a Z-direction running crosswise to the X- and Y-direction,
- At least four detection units (3, 3', 3", 3"'), whereupon:
a) At least two first detection units (3,3") can be moved at least in the X-direction and in the Y-direction, and
b) At least two second detection units (3', 3''') can be moved exclusively in Z-direction,
Contacting means for bringing into contact the first substrate (14), aligned relative to the second substrate (14'), with the second substrate (14') in the Z-direction, and
- A control system for controlling and detecting the movements of the substrates (14, 14') by means of the holders (4, 5) and for controlling and detecting the movement of the detection units (3, 3', 3", 3"') and for controlling and detecting the movement of the contacting means,
wherein the second substrate (14') that is fixed to the second holder (5) can be moved exclusively in the Z-direction, wherein the first substrate can be moved in the X- and/or Y-direction such that a left second detection unit (3') detects a left marking (17") on the first substrate (14),
- wherein the first substrate (14) can be moved in the X- and/or Y-direction such that a right second detection unit (3"') detects a right marking (17") on the first substrate (14),
- wherein a left first detection unit (3") can be moved in the X- and/or Y-direction such that a left marking (17") on the second substrate (14') is detected by the left first detection unit (3), wherein the second substrate (14') is moveable exclusively in the Z-direction,
- wherein a right first detection unit (3") can be moved in the X- and/or Y-direction such that a right marking (17") on the second substrate (14') is detected by the right first detection unit (3"), **characterized in that** the at least two first detection units (3, 3") are moveable independently from the first substrate (14) and that the at least two second detection units (3', 3''') are moved during detection exclusively in the Z-direction.

8. Device according to Claim 7, whereby the first holder (4) has an X-translational unit that can be run in particular exclusively in a linear manner, a Y-translational unit that can be run in particular exclusively in a linear manner, and a Z-translational unit that can be run in particular exclusively in a linear manner.

9. Device according to one of the claims 7 to 8, whereby the second holder (5) has a Z-translational unit that can be run in particular exclusively in a linear manner.

10. Device according to one of the claims 7 to 9, whereby the first detection units (3, 3") are arranged laterally opposite the first holder (4) or the second detection units (3', 3"') are arranged laterally opposite the second holder (5).

11. Device according to one of the claims 7 to 10, whereby the first detection units (3, 3") in each case have an X-translational unit that can be run in particular exclusively in a linear manner, a Y-translational unit that can be run in particular exclusively in a linear manner, and a Z-translational unit that can be run in particular exclusively in a linear manner.

12. Device according to one of the claims 7 to 11, whereby the second detection units (3', 3''') in each case have a Z-translational unit that can be run in particular exclusively in a linear manner.

13. Device according to one of the claims 7 to 12, whereby in each case, a first detection unit (3, 3") and in each case a second detection unit (3', 3"') can be arranged opposite to one another.

## Revendications

1. Procédé d'alignement et de mise en contact d'un premier substrat (14) avec un second substrat (14') comprenant les étapes suivantes, en particulier le déroulement suivant :
- fixation du premier substrat (14) sur une première réception (4) et du second substrat (14') sur une seconde réception (5) qui est agencée opposée à la première réception (4), dans lequel le premier et le second substrat (14, 14') sont agencés entre les première et seconde réceptions (4, 5) avec un écart A entre une première surface de contact du premier substrat (14) et une seconde surface de contact du second substrat (14'),
- détection de premiers marquages (17") du premier substrat (14) et de seconds marquages (17") du second substrat (14') par au moins quatre unités de détection (3, 3', 3", 3"'), dont :
a) au moins deux premières unités de détection (3, 3") peuvent être déplacées au moins dans au moins le sens X et le sens Y et
b) au moins deux secondes unités de détection (3', 3''') sont déplacées dans un sens Z transversal aux sens X et Y lors de la détection,
- alignement du premier substrat (14) par rapport au second substrat (14') dans un sens X et un sens Y transversal à celui-ci par le déplacement des substrats (14, 14') par les réceptions (4, 5) et
- mise en contact des surfaces de contact des substrats (14, 14') alignés dans le sens Z, dans lequel
le second substrat (14') fixé sur la seconde réception (5) peut être déplacé uniquement dans le sens Z,
dans lequel le premier substrat (14) est ainsi déplacé dans le sens X et/ou Y qu'une seconde unité de détection à gauche (3') détecte un marquage à gauche (17") sur le premier substrat (14),
dans lequel le premier substrat (14) est ainsi déplacé dans le sens X et/ou Y qu'une seconde unité de détection à droite (3"') détecte un marquage à droite (17") sur le premier substrat (14),
dans lequel une première unité de détection à gauche (3) est ainsi déplacée dans le sens X et/ou Y, qu'un marquage à gauche (17") est détecté sur le second substrat (14') par la première unité de détection à gauche (3), dans lequel le second substrat (14') est mobile uniquement dans le sens Z,
dans lequel une première unité de détection à droite (3") est ainsi déplacée dans le sens X et/ou y qu'un marquage à droite (17") est détecté sur le second substrat (14') par la première unité de détection à droite (3"), **caractérisé en ce que** les au moins deux premières unités de détection (3, 3") sont mobiles indépendamment du premier substrat (14) et que les au moins deux secondes unités de détection (3', 3"') sont déplacées exclusivement dans le sens Z lors de la détection.

2. Procédé selon la revendication 1, dans lequel l'alignement est réalisé sous vide à moins de 1 bar, de préférence moins de 10⁻³ bar, avec une plus grande préférence à moins de 10⁻⁵ bar, avec la plus grande préférence à moins de 10⁻⁷ bar et de la manière préférée entre toutes à moins de 10⁻⁹.

3. Procédé selon l'une des revendications précédentes, dans lequel les moyens de détection sont calibrés avant l'alignement, en particulier avec au moins un premier substrat de calibrage (13), de préférence en plus avec un second substrat de calibrage (13') formé différemment du premier substrat de calibrage (13).

4. Procédé selon la revendication 3, dans lequel le premier substrat de calibrage (13) est employé pour le calibrage d'axes optiques d'unités de détection pouvant être agencées respectivement à l'opposé et/ou pour le calibrage de la profondeur de champ des unités de détection par rapport au premier substrat de calibrage (13).

5. Procédé selon la revendication 3 ou 4, dans lequel le second substrat de calibrage (13') est employé pour le calibrage des premières unités de détection (3, 3") par rapport au mouvement du premier substrat (14) sur la première réception (4) dans le sens X et le sens Y.

6. Procédé selon l'une des revendications précédentes, dans lequel la commande et la détection des mouvements des substrats (14, 14') au moyen des réceptions (4, 5) et la commande et la détection du mouvement des unités de détection (3, 3', 3", 3''') et pour la commande et la détection du mouvement des moyens de contact sont commandés par un dispositif de commande.

7. Dispositif d'alignement et de mise en contact d'un premier substrat (14) avec un second substrat (14') comprenant :
- une première réception (4) pour la fixation et le déplacement du premier substrat (14) une seconde réception (5) agencée opposée à la première réception (4) pour la fixation et le déplacement du second substrat (14'), dans lequel le premier et le second substrat (14, 14') peuvent être alignés entre les première et seconde réceptions (4, 5) avec un écart A entre une première surface de contact du premier substrat (14) et une seconde surface de contact du second substrat (14') dans un sens X, un sens Y transversal à celui-ci et un sens Z transversal au sens X et au sens Y,
- au moins quatre unités de détection (3, 3', 3", 3"') dont :
a) au moins deux premières unités de détection (3, 3") peuvent être déplacées au moins dans au moins le sens X et le sens Y et
b) au moins deux secondes unités de détection (3', 3''') peuvent être déplacées dans un sens Z,
- des moyens de mise en contact pour la mise en contact du premier substrat (14) aligné en face du second substrat (14'), avec le second substrat (14') dans le sens Z et
- un dispositif de commande pour commander et détecter les mouvements des substrats (14, 14') au moyens des réceptions (4, 5) et pour commander et détecter le mouvement des unités de détection (3, 3', 3", 3"') et pour commander et détecter le mouvement des moyens de mise en contact,
dans lequel le second substrat (14') fixé sur la seconde réception (5) peut être déplacé uniquement dans le sens Z,
dans lequel le premier substrat (14) peut être ainsi déplacé dans le sens X et/ou Y qu'une seconde unité de détection à gauche (3') détecte un marquage à gauche (17") sur le premier substrat (14), dans lequel le premier substrat (14) peut être ainsi déplacé dans le sens X et/ou Y qu'une seconde unité de détection à droite (3"') détecte un marquage à droite (17") sur le premier substrat (14), dans lequel une unité de détection à gauche (3) peut être ainsi déplacé dans le sens X et/ou Y, qu'un marquage à gauche (17") est détecté sur le second substrat (14') par la première unité de détection à gauche (3), dans lequel le second substrat (14') est mobile uniquement dans le sens Z,
dans lequel une première unité de détection à droite (3") peut être ainsi déplacée dans le sens X et/ou y qu'un marquage à droite (17") est détecté sur le second substrat (14') par la première unité de détection à droite (3"),
**caractérisé en ce que** les au moins deux premières unités de détection (3, 3") sont déplacées indépendamment du premier substrat (14) et que les au moins deux secondes unités de détection (3', 3"') sont déplacées exclusivement dans le sens Z lors de la détection.

8. Dispositif selon la revendication 7, dans lequel la première réception (4) présente une unité de translation X pouvant être déplacée en particulier uniquement de façon linéaire, une unité de translation Y pouvant être déplacée en particulier uniquement de façon linéaire, et une unité de translation Z pouvant être déplacée en particulier uniquement de façon linéaire.

9. Dispositif selon la revendication 7 ou 8, dans lequel la seconde réception (5) présente une unité de translation Z pouvant être déplacée en particulier uniquement de façon linéaire.

10. Dispositif selon l'une des revendications 7 à 9, dans lequel les premières unités de détection (3, 3") sont agencées latéralement en face de la première réception (4) et/ou les secondes unités de détection (3', 3''') sont agencées latéralement en face de la seconde réception (5).

11. Dispositif selon l'une des revendications 7 à 10, dans lequel les premières unités de détection (3, 3") présentent respectivement une unité de translation X pouvant être déplacée en particulier uniquement de façon linéaire, une unité de translation Y pouvant être déplacée en particulier uniquement de façon linéaire, et une unité de translation Z pouvant être déplacée en particulier uniquement de façon linéaire.

12. Dispositif selon l'une des revendications 7 à 11, dans lequel les secondes unités de détection (3', 3"') présentent respectivement une unité de translation Z pouvant être déplacée en particulier uniquement de façon linéaire.

13. Dispositif selon l'une des revendications 7 à 12, dans lequel respectivement une première unité de détection (3, 3") et respectivement une seconde unité de détection (3', 3"') peuvent être agencées en face l'une de l'autre.
